# EUROPÄISCHE PATENTSCHRIFT

(11) **EP 3 716 744 B1**
(45) Veröffentlichungstag und Bekanntmachung des Hinweises auf die Patenterteilung: **10.03.2021**
(21) Anmeldenummer: 20162363.4
(22) Anmeldetag: 11.03.2020
(51) Int. Cl.: H05K 7/14, H01L 25/11, H02M 1/00

(54) **MODULARES ELEKTRONIKGEHÄUSEKONZEPT**
MODULAR ELECTRONICS HOUSING CONCEPT
CONCEPT DE BOITIER ÉLECTRONIQUE MODULAIRE

(30) Priorität: 29.03.2019 DE 102019002350
(43) Veröffentlichungstag der Anmeldung: 30.09.2020
(73) Patentinhaber: Sinn Power GmbH, 82131 Gauting (DE)
(72) Erfinder: SINN, Philipp, 82131 Gauting (DE); SCHWAIGER, Dominik, 82131 Gauting (DE)
(74) Vertreter: Erhardt, Martin

(56) Entgegenhaltungen:
- DE-A1-102012 220 280
- DE-B3-102014 104 308

## Beschreibung

Die Erfindung bezieht sich auf ein modulares Elektronikgehäusekonzept, bzw. auf ein Elektronikmodulkonzept mit einem Gehäuse zur Aufnahme von Elektronikbauteilen. In einem Gehäuse eines erfindungsgemäßen Elektronikmoduls können zumindest Platinen mit daran auf-, ein-oder angebrachten Elektronikbauteilen sowie weitere Anwendungsfall-bezogene Elektronikkomponenten aufgenommen werden.

Elektronikbauteile werden vielfältig in den unterschiedlichsten Anwendungen verwendet, wobei eine individuelle Zusammenstellung der Elektronikbauteile für jede Verwendung angestrebt wird. Gleichzeitig soll jedoch ein hohes Maß an Wiederholbarkeit von Gleich- und/oder Normteilen, insbesondere für Elektronikaufnahmevorrichtungen bzw. für deren Befestigung, bereitgestellt werden.

Mit Zunahme der Umwandlung regenerativer Energien und mit Zunahme der Elektromobilität werden auch im Leistungselektronikbereich die Anforderungen an eine individuelle Zusammenstellung der Elektronik- bzw. der Leistungselektronikbaugruppen immer höher, wobei eine modulare Zusammenstellung unter Ausnutzung möglichst vieler Gleich- bzw. Normteile schon aus Kostengründen immer wichtiger wird.

Aus DE 10 2012 220 280 A1 ist ein Elektronikgehäuse bekannt, welches Wandler, wie z.B. DC/DC-, AC/DC-, DC/AC- oder AC/AC-Wandler zur Spannungswandlung bzw. Frequenzumrichtung aufnehmen kann. Für den modularen Aufbau einer an die Verwendung angepassten Leistungselektronik werden Elektronikgehäuse bereitgestellt, welche mit einer Flansch-zu-FlanschVerbindung miteinander verbindbar sind, um so das Volumen des Elektronikgehäuses an die benötigte Leistungselektronik anzupassen.

DE 20 2006 009 669 U1 zeigt ein modular aufgebautes Gehäusesystem für die Aufnahme von Elektronikbauteilen, wobei das Gehäuse aus Strangpress-Profileinzelstücken zusammengesetzt ist. Das Gehäuse ist mittels geeigneter Profilverbindungsstücken, Frontblenden und Rückwänden sowie Seitenwänden quer zur Strangpressrichtung modular skalierbar.

DE 10 2014 104 308 B3 offenbart ein Leistungshalbleitereinrichtungssystem, das mehrere Leistungshalbleitereinrichtungen, ein für alle Leistungshalbleitereinrichtungen gemeinsames Aufsteckmodul und ein Dichtelement aufweist. Die Leistungshalbleitereinrichtungen sind über Steckverbindungen, die elektrische Signale übertragen können, mit dem Aufsteckmodul verbunden. Die Verbindung ist durch das Dichtelement abgedichtet. Sowohl die Leistungshalbleitereinrichtungen als auch das Aufsteckmodul stellen Schnittstellen zum Empfang bzw. zur Übertragung von Signalen von bzw. nach außerhalb des Leistungshalbleitereinrichtungssystems bereit.

Es ist Aufgabe der vorliegenden Erfindung Elektronikkomponenten in modularer Bauweise bereitzustellen, in denen sowohl eine bedarfsgerecht abgestimmte (Leistungs-)Elektronik als auch Elektronikbaugruppen aufgenommen werden können, wobei die Elektronik modular zur Anpassung für den jeweiligen Anwendungsfall in einfacher Art und Weise zusammengestellt werden kann. Dabei sollen aufwändige Montagearbeiten, insbesondere zum Erzielen einer ausreichenden (Ab-)Schirmung weitestgehend vermieden werden. Für die Aufnahme und den Aufbau einer für den Anwendungsfall spezifisch ausgelegten Elektronik soll dabei ein mit einfachen, robusten und kostengünstigen Mitteln herstellbares Gehäuse bereitgestellt werden, mit dem sich die für den jeweiligen Anwendungsfall erforderliche Elektronik modular zusammenstellen lässt.

Die Aufgabe wird mit einem Elektronikmodul gemäß Anspruch 1 gelöst, das ein Gehäuse aufweist, in welchem Elektronikbauteile bzw. Leistungselektronikbauteile, wie Spannungswandler, Frequenzumrichter, Widerstände, Kondensatoren, Akkumulatoren, Batterien und dergleichen, aufgenommen werden können. In einer Längsrichtung ist die Höhe/Länge des Gehäuses durch zwei Stirnseiten begrenzt, die jeweils eine Öffnung aufweisen. Durch diese Öffnungen kann das Gehäuse zumindest mit einer ersten Platine und zumindest mit einer zweiten Platine bestückt werden. Hierbei werden im Wesentlichen zwei Arten von Platinen verwendet, eine erste Platine (Funktionsplatine), die mit Elektronikbauteilen zur Spannungswandlung und/oder zur Frequenzumrichtung und/oder Ähnlichem bestückt ist und einer zweiten Platine (Leitungsplatine), welche die Leistungs- und Kommunikationsverbindung der zumindest einen ersten Platine mit der zweiten Platine kabellos herstellt. Die zweite Platine weist zudem an zumindest einem freien Ende - bevorzugt das Ende, dass beim montierten Elektronikmodul an der Öffnung zum Liegen kommt - weitere geeignete Steck- und/oder Klemm-Verbindungsmittel auf, sodass eine weitere zweite Platine daran angebunden werden kann, um die Übertragung von elektrischer Leistung und Kommunikationsignalen zwischen den zweiten Platinen bereitzustellen. Hierzu kann die zweite Platine beispielsweise mit einer zweiten Platine eines weiteren Elektronikmoduls verbunden werden oder auch mit einer weiteren zweiten Platine innerhalb desselben Gehäuses.

Mit der erfindungsgemäßen Ausgestaltung der zweiten Platine mit zumindest zwei Steck- und/oder Klemm-Verbindungsmittel - eines für die Verbindung mit der ersten Platine und eines für die Anbindung einer weiteren zweiten Platine - können alle Verbindungen zum Weiterleiten von elektrischer Leistung und Kommunikationssignalen sowohl innerhalb des Gehäuses als auch zwischen den Modulen kabellos ausgeführt werden. Damit wird einerseits eine aufwendige, meist manuell ausgeführte, Verbindung mit Schirmungen zwischen einzelnen Elektronikbauteilen vermieden. Andererseits können speziell über die Kommunikationsverbindungen zusätzlich zu Kommunikationssignalen auch Steuer-, Schalt- und/oder Messsignale übertragen bzw. weitergeleitet werden. All diese Signale werden in der weiteren Beschreibung der vorliegenden Erfindung unter den Begriff Kommunikationssignale zusammengefasst.

Zum Bestücken eines erfindungsgemäßen Elektronikmoduls können mehrere erste Platinen mit einer zweiten Platine verbunden sein, wobei beispielsweise auch zwei zweite Platinen zum Einsatz kommen können, so dass das Elektronikmodul von beiden Seiten mit Baugruppen, die eine oder mehrere erste Platinen und eine zweite Platine aufweisen, bestückt werden kann. Die Verbindung der beiden zweiten Platinen innerhalb des Gehäuses erfolgt dabei ebenfalls über geeignete Steck- und/oder Klemm-Verbindungsmittel.

In einer weiteren Ausführungsform können mehrere ersten Platinen parallel zueinander im Wesentlichen quer zur Gehäuselängsrichtung in das Gehäuse eingesetzt werden und dort an Domen festgesetzt werden. Dabei ist vorstellbar auch die zweite Platine in ihrer Lage im Gehäuse, gleichzeitig über die Steck- und/oder Klemmverbindung der ersten mit der zweiten Platine festzusetzen. Erfindungsgemäß wird bevorzugt, die zumindest eine zweite Platine über Aufnahmenuten, die an jeweils gegenüberliegenden Innenseiten der Gehäusewandung angeordnet sind, in das Gehäuse einzuschieben. Im Rahmen der Erfindung ist ebenfalls vorgesehen, dass Aufnahmenuten zusätzlich oder alternativ zu den Aufnahmenuten an der Gehäuseinnenseite an mindestens zwei gegenüberliegenden Domen vorgesehen sind. Hiermit lassen sich mehrere in Längsrichtung ausgerichtete erste und/oder zweite Platinen parallel zueinander aufnehmen. Diese sind mit ersten Platinen, die in Querrichtung beispielsweise an den Domen angeschraubt sind, über entsprechende Steck- und/oder Klemmverbindungsmittel verbindbar. Erfindungsgemäß sind an den nach außen weisenden Rändern der zweiten Platinen Steck- und/oder Klemm-Verbindungsmittel angeordnet, mit denen die jeweiligen zweiten Platinen weiterer Elektronikmodule kabellos zum Weiterleiten von elektrischer Leistung und Kommunikationssignalen miteinander verbunden werden können.

Durch die Kombination eines einfach aufgebauten Gehäuses mit einer in Längsrichtung verlaufenden Gehäusewandung, an der zumindest ein Dom an einer Innenseite angeordnet ist und an der an mindestens zwei paarweise gegenüberliegenden Gehäuseinnenseiten und/oder Domen jeweils eine Aufnahmenut ausgebildet ist, kann somit in einer einfachen und kostengünstigen Art und Weise zumindest eine mit Elektronikbauteilen versehene Platine, die im Wesentlichen quer zur Längsrichtung ausgerichtet ist, an dem zumindest einen Dom befestigt werden. Durch zweite Platinen, bzw. Verbindungsplatinen, die im Wesentlichen in Längsrichtung des Gehäuses ausgerichtet sind, wird weiter eine einfache, jedoch zuverlässige, ohne viel Abschirmaufwand erzielbare Leistungs- und Kommunikationsverbindung zwischen den Platinen eines Elektronikmoduls als auch zwischen den Platinen mehrerer Elektronikmodule bereitstellt.

Mit der erfindungsgemäßen Idee können Elektronik-Vormontagegruppen über die Aufnahmenuten in das Gehäuse eingeschoben werden und beispielsweise mittels eines Doms im Gehäuse in Längsrichtung fixiert werden, wobei die Aufnahmenuten gleichzeitig eine Fixierung in Richtungen quer zur Längsrichtung bereitstellen. Selbstredend fällt eine Anbindung an zwei oder mehreren im Gehäuse ausgebildeten Domen in den Bereich des fachmännischen Könnens und ist somit vom Erfindungsgedanken umfasst. Auch das Ausbilden eines Durchgangsloches, eines Sackloches und/oder eines darin befindlichen Gewindes in einem oder mehreren Domen zum Befestigen der ersten Platine mittels einer Schraubverbindung, liegt ebenfalls im Bereich des fachmännischen Könnens und ist ebenfalls von der Erfindung umfasst. Jedoch sind alle anderen Verbindungsarten zum Festsetzen der zumindest einen ersten Platine, wie beispielsweise mittels Klemmstiften, Kleben, Löten, Schweißen oder ähnliches ebenfalls erfindungsgemäß vorstellbar.

Für den Fachmann ist dabei ersichtlich, dass zur Anordnung der ersten Platine quer zur Längsrichtung und somit auch zum Positionieren der zweiten Platine in Längsrichtung, die Dome mit oder ohne Aufnahmenuten an der Gehäuseinnenseite in ihrer Höhe bzw. Länge anpassbar sind. Daraus folgend ist es erfindungsgemäß, die Höhe bzw. die Länge der Dome in Längsrichtung des Gehäuses auf die jeweilige Anwendung anzupassen. Dabei ist es ebenfalls vom Erfindungsgedanken umfasst, die Längen bzw. Höhen der einzelnen Dome bereits bei der Herstellung des Gehäuses unterschiedlich auszuführen oder dies nachträglich in einem materialabtragenden Verfahren auszuführen, um die Position einer ersten Platine im Gehäuse variieren zu können oder mehrere erste Platinen parallel zueinander im Gehäuses anordnen zu können. Im letzteren Fall haben die einzelnen Platinen entsprechende Freimachungen, so dass die für die Befestigung einer Platine nicht benötigten Dome durch die Freimachungen hindurchtauchen können und für die Befestigung einer anderen Platine oder eines weiteren Elektronikbauteils zu Verfügung stehen. Weiter erfindungsgemäß können die Gehäuse der Elektronikmodule von beiden Stirnseiten über die jeweiligen Öffnungen bestückt werden, so dass auch hier erfindungsgemäß die Höhe bzw. Länge der Dome von beiden Seiten anpassbar ist.

Erfindungsgemäß werden die Gehäuse der Elektronikmodule bevorzugt durch Urformen aus einem Metall, beispielsweise im Strangpress-, Strangguss-, oder (Druck-) Gussverfahren, bevorzugt aus Aluminium oder aus einer Aluminiumlegierung hergestellt. Ebenso ist eine Herstellung in einem spanenden Verfahren oder auch im Niederdruckverfahren vorstellbar, jedoch für den Einzelfall hinsichtlich seiner Kosten abzuwägen. Andere Materialien sind für die Herstellung des Gehäuses des erfindungsgemäßen Elektronikmoduls, wie z.B. Zink oder Magnesium, je nach Anwendungsfall ebenfalls denkbar. Weiter kann beispielsweise Kunststoff als Gehäusematerial in Erwägung gezogen werden, da dieser sich gut im Spritzguss- oder Extrudierverfahren formen lässt. Im Allgemeinen kommen zur Herstellung des Gehäuses bevorzugt kontinuierliche oder semikontinuierliche Verfahren zur Anwendung, wie beispielsweise ein Strangpressen oder Extrudieren. Aber auch eine Serienteil-Fertigung oder eine Einzelteil-Fertigung sind vorstellbar und können aus wirtschaftlichen oder qualitativen Gründen bevorzugt sein.

Werden kontinuierliche oder semikontinuierliche Verfahren zur Herstellung des Gehäuses verwendet, verlaufen die Dome entlang der kompletten Höhe der Gehäusewandung von einer Stirnseite zur anderen Stirnseite, da in diesen Verfahren lange bzw. endlose Profile erzeugt werden und durch geeignetes Ablängen die erfindungsgemäßen Gehäuse entstehen. Das bedeutet, dass diese vollständig zwischen den beiden Stirnseiten ausgebildeten Dome gegebenenfalls durch Nachbearbeitung in ihrer Länge bzw. Höhe angepasst werden müssen. Dabei ist es bevorzugt eventuelle Schlitze bzw. Aufnahmenuten in den Domen schon beim Herstellen der Gehäuse auszuformen. Der Fachmann erkennt, dass solche Aufnahmenuten/Schlitze in Domen auch nachträglich einbringbar sind, wobei dies in den meisten Fällen aufwändiger sein dürfte. In anderen Verfahren, wie beispielsweise Gussverfahren oder Spritzgussverfahren können die Dome in ihrer jeweilig benötigten Länge mit und ohne Schlitze gleich so ausgeformt werden, dass eine spätere Nacharbeit evtl. entfallen kann. Für eine universellere Verwendung der einzelnen Gehäuse ist es jedoch auch hier vorstellbar, die Dome von einer Stirnfläche zur anderen Stirnfläche durchlaufen zu lassen. Eine spätere Anpassung an den speziellen Anwendungsfall wäre hierdurch weiterhin gegeben.

In einer beispielhaften Ausführungsform des Gehäuses sind in der Gehäusewandung in Längsrichtung Flüssigkeitskühlkanäle eingebracht, die eine direkte Flüssigkühlung des Gehäuses bzw. eine indirekte Flüssigkühlung der innerhalb der Gehäusewandung angeordneten Elektronikbauteile ermöglichen, wenn deren Abwärme an die Gehäusewandung bzw. auf die Flüssigkeitskühlkanäle übertragen wird. Bei einer Aneinanderreihung von mindestens zwei Elektronikmodulen in Längsrichtung ist ein Weiterleiten von Kühlflüssigkeit zwischen den einzelnen Gehäuseteilen über die Kühlkanäle möglich, wobei Dichtmittel zwischen den beiden Gehäusen angeordnet sein können.

Zusätzlich oder auch alternativ zu den zuvor angesprochenen Flüssigkeitskanälen kann die profilierte Gehäusewandung auch Kühlrippen aufweisen, die sich im Wesentlichen in Ebenen parallel zur Längsrichtung erstrecken, damit sie im Herstellungsverfahren form- bzw. entformbar sind. Diese Kühlrippen stehen bevorzugt nach außen vor, um von der Elektronik generierte Wärme innerhalb des Gehäuses an die Umgebung abgeben zu können. Hierbei ist es ebenfalls möglich, dass die Kühlrippen auch nach innen, in das Gehäuse hinein, vorstehen, damit innerhalb der Gehäusewandung generierte Wärme in unmittelbarer Nähe der Wärmequelle aufgenommen werden kann, um von den Kühlrippen, beispielsweise mittels der guten Wärmeleitfähigkeit von Aluminium, nach außen zur Außenseite der Gehäusewandung geleitet zu werden, von wo aus die Wärme an die Umgebung abstrahlt. In einer weiteren Ausführungsform können zur weiteren Verbesserung der Wärmeabfuhr aus dem Gehäuseinneren auch die Dome mit Kühlrippen versehen werden. Dabei ist ebenso vorstellbar, dass insbesondere nicht bearbeitete Dome, also Dome die von einer Stirnseite zur anderen Stirnseite verlaufen, auch als Fluidkanal verwendet werden können. Insbesondere im Zusammenspiel zwischen außen und innen vorstehenden Kühlrippen und zusammen mit Flüssigkeitskanälen, die in oder an der Gehäusewandung oder in den Domen verlaufen, kann somit durch die Kombination von Luft- und Flüssigkühlung eine gute Kühlwirkung für die im Elektronikmodul aufgenommene Elektronik bereitgestellt werden, insbesondere für eine Leistungselektronik mit beispielsweise Halbleiterbauelementen, wie MOSFETs oder Ähnlichen.

In einer weiter bevorzugten Ausgestaltung des erfindungsgemäßen Gehäuses verlaufen die Flüssigkeitskühlkanäle integriert in den Kühlrippen, so dass die im Gehäuse entstehende Wärme an flüssigkeitsgekühlte Kühlrippen abgegeben werden kann. Auch so ist ein guter Wärmeübertrag von einer Wärmequelle im Gehäuseinneren zur Außenseite des Gehäuses erreichbar.

In einer weiteren Ausführungsform kann an dem zumindest einen Dom zusätzlich zumindest eine federnde Klammer derart befestigt werden, dass die Klemmkraft im Wesentlichen quer oder schräg zur Längsrichtung wirkt. Hierbei wird die Klammer bevorzugt in Längsrichtung mit dem Dom verschraubt, wobei dies gleichzeitig mit dem Festsetzen der ersten Platine erfolgen kann oder auch von der nicht von einer Platine belegten Seite des Domes. Im Sinne der Erfindung kann die Klammer vor oder nach dem Einbringen der ersten Platine gesetzt werden, und so etwa eine Andrückkraft für die erste Platine in Richtung Verbindungsstelle mit der zweiten Platine erzeugen.

In einer anderen bevorzugten Ausführungsform können weitere Elektronikbauteile, beispielsweise ein MOSFET, mittels der federnden Klammer, die an zumindest einem Dom befestigt ist, so gegen die Gehäusewandung gedrückt werden, dass eine flächige Wärmeleitung zwischen dem Elektronikbauteil und der Innenseite der Gehäusewandung möglich ist. Eine solche Anordnung ist im Falle von thermisch hochbelasteten, d.h. viel Wärme erzeugenden Elektronikbauteilen bevorzugt, da diese eine hohe Kühlleistung benötigen. In der Umsetzung einer solchen Anordnung, beispielsweise für MOSFETs, werden diese beispielsweise so auf der ersten Platine platziert, dass sie nach einem Einsetzen der ersten Platine neben dem zumindest einen Dom, oder falls mehrere Dome vorhanden sind, zwischen den Domen positioniert sind. Im Anschluss wird die Klammer von der jeweils anderen Seite an dem Dom befestigt, so dass die Federkraft der federnden Klammer das Elektronikbauteil durch die Federkraft flächig an die Innenseite der Gehäusewandung gedrückt wird. Dadurch kann die im Elektronikbauteil, beispielsweise im MOSFET, im Betrieb generierte Wärmeleistung gut an die Gehäusewandung abgegeben werden, wobei die Gehäusewandung durch Kühlrippen und/oder Flüssigkeitskanäle gekühlt werden kann, wie oben bereits erläutert. Dem Fachmann ist dabei bewusst, speziell bei der Verwendung von Metallgehäusen, dass er gegebenenfalls auf eine elektrische Isolation zwischen Gehäusewandung und Elektronikbauteil achten muss, um Kurzschlüsse zu vermeiden. Üblicherweise stellen die Gehäuse der Elektronikbauteile bereits eine solche elektrische Isolierung bereit.

Das zuvor für nur ein weiteres Elektronikbauteil (MOSFET) beschriebene Ausführungsbeispiel und einer Klammer, lässt sich auch auf eine Mehrzahl von solchen Elektronikbauteilen anwenden, in dem beispielsweise eine Klemmleiste verwendet wird, die mehrere federnde Klammern aufweist, welche die Elektronikbauteile bevorzugt zwischen den Domen an die Innenseite der Gehäusewandung andrücken. Hierbei ist es ebenfalls vorstellbar, dass die Klemmleiste mit verschiedenartigen Federn ausgestattet ist, so dass verschiedenartige zwischen den Domen positionierbare Elektronikbauteile, wie MOSFETs, Widerstände, Spulen, Kondensatoren, etc. in der erfindungsgemäßen Art und Weise flächig gegen die Innenfläche der Gehäusewandung gedrückt werden können. In nachvollziehbarer Weise können hierbei sowohl Einzelklammern als auch Klemmleisten so an die Dome des Gehäuses befestigt werden, dass die jeweilige Klammer zwischen zwei Domen ihre Federwirkung ausüben kann. Bevorzugt wird die Klammer oder auch die Klemmleiste dabei an den Dom bzw. die Dome angeschraubt, was gegebenenfalls ein Gewinde im jeweiligen Dom erfordert, welches zuvor eingebracht wurde. Alternativ hierzu können die Dome auch Durchgangslöcher aufweisen, in die beispielsweise selbstschneidende Schrauben eingedreht oder Gewindeeinsätze eingesetzt werden können. Dabei ist es beim Festsetzen einer Klammer oder einer Klemmleiste unerheblich, ob der oder die Dome, an dem/denen die Klammer bzw. die Klemmleiste befestigt wird, mit einem Schlitz bzw. einer Aufnahmenut für längs ausgerichtete Platinen versehen sind.

Im Bereich des fachmännischen Könnens liegt hierbei aber nicht nur, dass die Klammern oder die Klemmleiste an Domen, die an der Gehäuseinnenseite ausgebildet sind, angeordnet werden. Das Anordnen einer Klammer oder einer Klemmleiste an Domen, die außen am Gehäuse angeordnet sind, ist ebenso vom Erfindungsgedanken umfasst, wie das Anordnen von zumindest einer Klammer oder Klemmleiste an Kühlrippen, Durchgangslöchern oder Flüssigkeitskanälen, die jeweils im Inneren und/oder an der Außenseite des Gehäuse ausgebildet sind, ist hierbei vom Erfindungsgedanken umfasst. Die Wahl einer adäquaten Befestigungsmethode, beispielsweise Schrauben oder Schweißen, und das Hinzufügen von Befestigungshilfsmitteln, wie beispielsweise das Einsetzen von Gewindeeinsätzen, sind dabei vom fachmännischen Können umfasst.

Beim modularen Zusammensetzen der Gehäuse der Elektronikmodule zum Ausbilden von beispielsweise Elektronikbaugruppen ist bevorzugt eine Staub- und/oder Wasserdichtheit zwischen den Gehäuse-Fügeflächen gefordert, welche beispielsweise durch eine entsprechende Dichtfläche an den Stirnflächen oder durch eine Dichtkontur an den Stirnflächen zur Aufnahme eines O-Rings realisiert werden kann. Hierfür ist es speziell bei kontinuierlichen/semikontinuierlichen Herstellverfahren für das Gehäuse bevorzugt, die Stirnflächen nachträglich zu bearbeiten, wenn die Gehäuse(abschnitte) aus einem langen Profilstrang herausgeschnitten werden. Werden solche Gehäuseabschnitte verwendet, können die Dome zur Befestigung der ersten Platine beispielsweise in der gleichen Aufspannung auf einer Werkzeugmaschine gleich mitbearbeitet werden. Jedoch kann je nach Anforderung an die Gehäuseverbindung bzw. je nach Anforderung an die Flexibilität der Lage der Platinen im Gehäuse und erforderlicher Stückzahl bevorzugt ein kontinuierliches oder semikontinuierliches oder eine Einzelteilfertigung für das Gehäuse in Betracht gezogen werden.

In einer weiteren Ausführungsform weist das Gehäuse des erfindungsgemäßen Elektronikmoduls eine in Umfangsrichtung geschlossene, rahmenartige, profiliert ausgebildete Gehäusewandung in Art eines z.B. Rohres oder eines Rechteckkanals auf. Insbesondere, wenn das Gehäuse in einem Strangpress-, Stranggieß-, oder Extrudierverfahren hergestellt wird, laufen alle profilgebenden Konturen ohne Unterbrechung von einer Stirnfläche zur anderen Stirnfläche. Wie dem Fachmann geläufig, sind bei den zuvor genannten Herstellverfahren lange bis sehr lange und gegebenenfalls auch endlose Profile herstellbar, welche für das erfindungsgemäße Elektronikmodul in Einzelabschnitte unterteilt werden. Dabei kann die Höhe des Gehäuses in Längsrichtung abhängig vom Anwendungsfall abgelängt und variiert werden. Generell ist es daher denkbar, dass beim Aufbau einer (Leistungs-)Elektronik, beispielsweise für ein Wellenkraftwerk, die Gehäuse als nicht zugeschnittene Stränge vorliegen, die beispielsweise vom Hersteller des Wellenkraftwerks vorort in geeigneter Art und Weise abgelängt werden können. Wie oben bereits angedeutet, müssen nach einem Ablängen der einzelnen Gehäuse gegebenenfalls die Stirnflächen als auch die Domhöhe(n) für die geeignete Aufnahme der ersten Platinen, mit den daran befindlichen Elektronikbauteilen, angepasst werden. Die Bearbeitung der Stirnflächen ist gegebenenfalls deshalb notwendig, damit eine ebene Dichtfläche oder eine Dichtkontur zur Aufnahme einer Flachdichtung oder einer O-Ringdichtung bereitgestellt werden kann. Die Verwendung einer zusätzlichen Dichtung kann gegebenenfalls entfallen, wenn die Stirnflächen bzw. Dichtflächen derart exakt oberflächenbearbeitet sind, so dass eine direkte Anlage zweier Dichtflächen zur Abdichtung der Elektronik ausreicht. Hierbei kann je nach Anwendungsfall auch eine staubdichte Abdichtung ausreichend sein. Weitere Möglichkeiten der Abdichtung zweier Gehäuse sind dem Fachmann geläufig, wie z.B. Klebedichtungen aus Silikon, die Verwendung von Weichdichtungen oder die Anwendung von Dichtungsschäumen, etc., und sind daher vom Erfindungsgedanken umfasst.

In anderen Anwendungsfällen, insbesondere wenn die erfindungsgemäßen Elektronikmodule im Freien benutzt werden, ist häufig zumindest eine wasserdichte Abdichtung zwischen den Gehäusen notwendig. Des Weiteren ist eine fluiddichte Abdichtung zwischen den Gehäusen insbesondere dann angezeigt, wenn Kühlflüssigkeit zum Kühlen des Gehäuses bzw. der darin aufgenommenen Elektronikbauteile, in Flüssigkeitskanälen, die in Längsrichtung in der Gehäusewandung der Gehäuse eingebracht sind, von einem Gehäuse zum anderen Gehäuse weitergeleitet werden soll. Diese Kühlkanäle können dabei außerhalb und/oder innerhalb einer Dichtkontur angeordnet sein, wobei bei innerhalb der Dichtkontur angeordneten Fluidkanälen eine (zusätzliche) Abdichtung zwischen den einzelnen Fluidkanälen, insbesondere im Übergang von einem Gehäuse zum anderen Gehäuse, gewährleistet sein sollte.

Für das erfindungsgemäße modulare Zusammensetzen von Elektronikmodulen in Längsrichtung sind in der Gehäusewandung bevorzugt Durchgangslöcher vorgesehen, mittels denen die einzelnen Gehäuse mit einer Schraub- oder Klemmverbindung zusammengehalten werden können. Mittels dieser Durchgangslöcher ist eine in Längsrichtung wirkende Kraft senkrecht zu den Stirnflächen erzeugbar, wodurch nicht nur ein Kraftfluss über die Gehäusewandungen übertragbar ist, sondern auch ausreichend hohe Presskräfte auf die eventuell zwischen den Gehäusen und/oder Flüssigkeitskanälen vorhandenen Dichtungen erzielbar sind. Analog zu den Flüssigkeitskanälen können auch die Durchgangslöcher integral mit den Kühlrippen ausgebildet sein, um beispielsweise den Bauraum der Gehäuse klein zu halten, wobei gleichzeitig die Wärmeabstrahlfläche maximiert wird. Für den Fachmann ist es dabei nachvollziehbar, dass diese Durchgangslöcher zur Verbindung mehrerer Gehäuse in Längsrichtung sowohl außerhalb einer Dichtkontur, als auch innerhalb einer Dichtkontur, angeordnet sein können. Des Weiteren ist für den Fachmann ersichtlich, dass die Durchgangslöcher mit einem Gewinde versehen werden können, beispielsweise um mehrere Elektronikmodule nacheinander in Längsrichtung durch Schraubverbindungen anzuordnen. Auch das Anordnen von Gewindeeinsätzen in den Durchganslöchern ist vom Erfindungsgedanken umfasst.

In einer weiteren Ausführungsform können diese Durchgangslöcher auch Fluidkanäle darstellen und umgekehrt. Dementsprechend können in die einzelnen Durchgangslöcher bzw. Flüssigkeitskanäle hohlgebohrte Passstifte eingesetzt werden, die einerseits die Verbindung der Flüssigkeitskanäle bzw. Durchgangslöcher ermöglichen und gleichzeitig eine Dichtung zwischen den Flüssigkeitskanälen bereitstellen, als auch als Positionier- oder Zentrierstifte wirken. Selbstredend können erfindungsgemäß in nicht verwendete Durchgangslöcher bzw. Fluidkanäle auch Vollmaterialpassstifte zum Positionieren und Zentrieren zweier benachbarter Gehäuse zur Anwendung kommen. Solche Passstifte, ob hohl oder massiv, können dabei gleichzeitig auch, beispielsweise durch Variieren von Länge, Durchmesser, Querschnitt etc., als Falsch-Montageschutz dienen und eine gewisse Sicherheit bieten, dass nur solche Elektronikmodule miteinander verbindbar sind, die auch zueinander passen bzw. kompatibel sind.

Werden jedoch Passhülsen oder ähnliches, wie zuvor beschrieben, in die Durchgangslöcher bzw. Fluidkanäle eingesetzt, so ist deren Eignung als Aufnahmen für Befestigungsmittel oder zum Durchleiten von Kühlmitteln weiterhin gegeben. In einer speziellen Ausführungsform können diese hohlen Passstifte auch Rohre sein, die in die Fluidkanäle eingesetzt werden können, wobei, bei Durchführen der Rohre durch mehrere Elektronikmodule eine entsprechende Abdichtung der einzelnen Gehäuse gegebenenfalls entfallen kann. Unter den Begriff Rohre fallen auch flexible Rohre, wie z.B. Schläuche. Insbesondere bei der Verwendung von Aluminium oder Aluminiumlegierungen als Gehäusematerial kommen zum Schutz von Kühlpumpen häufig Kupferrohre oder Kunststoffschläuche zur Anwendung. Sind solche Rohre bzw. Schläuche zum Zirkulieren von Kühlflüssigkeit vorgesehen, können die Dome, welche die Kühlmittelleitungen aufnehmen, auch geschlitzt ausgeführt sein und so gleichzeitig als Aufnahmen für in Längsrichtung anordenbare Platinen dienen.

In einer weiteren Ausführungsform der Erfindung können beispielsweise Abschlussbauteile, die das/die Gehäuse in Längsrichtung verschließen, an einem erfindungsgemäßen Elektronikmodul oder an einer erfindungsgemäßen Aneinanderreihung von Elektronikmodulen befestigt werden. Die Verbindung zwischen Gehäuse und den Abschlussbauteilen kann dabei mittels einer Dichtung staubdicht oder fluiddicht ausgestaltet sein. Zum Verbinden eines Abschlussbauteils und eines Elektronikmoduls ist dem Fachmann eine Vielzahl von Verfahren bekannt. So können die Abschlussbauteile beispielsweise Durchgangslöcher aufweisen, in denen eine Gewindestange aufgenommen ist, die ebenfalls in den dazu kollinear angeordneten Durchgangslöchern eines oder mehrerer Elektronikgehäuse aufgenommen ist. Durch das Anziehen von Muttern, die außenliegend auf gegenüberliegenden Seiten der Gewindestange aufgeschraubt werden, kann eine Klemmkraft erzeugt werden, die die Gehäuse und Abschlussbauteile zusammenpresst. In einer anderen Ausführungsform können in den Gehäusen Gewindebohrungen vorgesehen sein, die mit Durchgangsbohrungen in den Abschlussbauteilen fluchten und mittels derer die Abschlussbauteile mit den Gehäusen verschraubt werden können. Dem Fachmann sind jedoch viele weitere Verfahren oder Mechanismen bekannt, wie Abschlussbauteile mit einem oder mehreren Gehäusen verbunden werden können. Insbesondere sind neben den oben beschriebenen auch form- und/oder stoffschlüssige Verfahren vom Erfindungsgedanken umfasst. In einer weiteren Ausgestaltung der Erfindung können die Abschlussbauteile Steck- und/oder Klemm-Verbindungsmittel zum kabellosen Verbinden und Weiterleiten von elektrischer Leistung und Kommunikationssignalen zu und von den ersten und zweiten Platinen, die im Gehäuse angeordnet sind, aufweisen.

Zur weiteren thermischen Regulation, insbesondere zwischen einzelnen Elektronikmodulen, können thermische Isolatoren, wie Isolationsschichten, etc. eingesetzt werden, sodass ein Wärmeübertrag von einem Elektronikmodul auf ein anderes Elektronikmodul vermieden wird.

In einer weiteren Ausführungsform sind an den Gehäuseaußenseiten Führungsnuten und/oder Führungssteine angeordnet, die eine seitliche Verbindung zweier Gehäuse zulassen, indem diese Führungselemente in Längsrichtung ineinander geschoben werden können. Diese, beispielsweise in Art einer schwalbenschwanz-Form ausgebildeten Führungsnuten und Führungssteine, können dabei ohne weitere Hilfsmittel Kräfte in einer Richtung quer zur Längsrichtung übertragen. Eine Fixierung in Längsrichtung kann hierbei über die zuvor angesprochenen Durchgangslöcher an eine geeignete Befestigungsvorrichtung erfolgen. Solche geeigneten Befestigungsvorrichtungen, wie beispielsweise eine Stromschiene oder ein Schaltschrank oder ähnliches, kann wiederum ein Führungsschienengegenstück, d.h. einen Führungsstein oder umgekehrt eine Führungsschiene aufweisen, mittels denen ein Gehäuse an einer solchen Befestigungsvorrichtung angebracht werden kann.

In einer weiteren Ausführungsform können die an der Gehäuseaußenseite angeordneten Führungsschienen einen Hinterschnitt, der quer zur Längsrichtung angeordnet ist, aufweisen. In diesen können in Teilbereichen komplementär ausgebildete Verbindungselemente eingesetzt werden, um eine Verbindung zwischen zwei oder mehreren Gehäusen und/oder zwischen dem Gehäuse und einer Montageschiene herzustellen. Für die Form der Verbindungselemente ist ein im Wesentlichen symmetrischer Aufbau vorgesehen, bevorzugt in der Form eines Doppel-T, einer doppelten Schwalbenschwanzführung oder eines Knochen. Hierbei ist auch vom Erfindungsgedanken umfasst, eine asymmetrische Form für die Verbindungselemente vorzusehen, zum Beispiel, um ein Gehäuse an eine Montageschiene anzubinden, die eine zum Gehäuse unterschiedliche Führungsschiene aufweist.

Es ist vom Erfindungsgedanken sowohl eine ein- als auch eine mehrteilige Ausführung der Verbindungselemente umfasst. So können theoretisch beliebig viele Teilungsebenen in dem Verbindungselement vorgesehen werden, die zueinander parallel, aber auch in einem Winkel angeordnet sein können. Zur leichteren Montier- und Fertigbarkeit kann beispielsweise die Symmetrieebene des Verbindungselements, sofern vorhanden, als Teilungsebene festgelegt werden und das Verbindungselement so in zwei gleichförmige Bestandteile aufgeteilt werden. Zum Verbinden der einzelnen Bestandteile zu einem Verbindungselement wird der Fachmann leicht ein passendes Verfahren auswählen, das beispielsweise kostengünstig ist und eine einfache Montage ermöglicht. Hier kommen als Verfahren beispielsweise Verschrauben, Schweißen, Löten, formschlüssige Verbindungen, etc. in Frage.

Dem Fachmann sind zahlreiche Methoden geläufig, wie das Verbindungselement an der zum Verbindungselement komplementär ausgebildeten Führungsschiene befestigt werden kann. So ist beispielsweise eine Befestigung durch Form-, Kraft- und/oder Stoffschluss, insbesondere durch beispielsweise Löten, Schweißen, Kleben, Klemmen, Schrauben, etc. denkbar.

In einer bevorzugten Ausführungsform weist das Verbindungselement zwei außen liegende Gurte und einen Steg auf, der die beiden Gurte verbindet, ähnlich dem Querschnitt eines Doppel-T-Trägers. Mindestens einer der beiden Gurte kann mit einer zum Gurt komplementär ausgebildeten Führungsschiene eines Gehäuses oder einer Montageschiene verbunden werden. In der bevorzugten Ausführungsform ist in dem mit der Führungsschiene verbundenen Gurt eine Vorrichtung angeordnet, mittels derer der Gurt gegen die Führungsschiene verspannt werden kann. Neben vielen anderen Möglichkeiten könnte der Fachmann beispielsweise das Einschrauben einer konischen Schraube in eine in einem Schlitz im Gurt angeordnete Gewindebohrung als Lösung zu Verspannen des Gurtes gegen die Führungsschiene vorsehen.

In einer weiteren bevorzugten Ausführungsform des erfindungsgemäßen Elektronikmoduls sind die Verbindungselemente mehrteilig und klemmbar ausgeführt. Die Verbindungselemente weisen eine Doppel-T-Träger-ähnliche Form auf und sind in ihrer Symmetrieebene, die die Längsachse des Steges einschließt, geteilt. Die beiden Teile werden beispielsweise durch Schrauben und Muttern zu einem Verbindungselement zusammengefügt. Jeder Gurt des doppel-T-förmigen Verbindungselements weist zwei Enden auf, die in den Führungsschienen von zwei Elektronikmodulen angeordnet werden können. Ein Klemmmechanismus klemmt die Gurtenden des Verbindungselements gegen die Führungsschiene und verhindert so ein Herausfallen der Verbindungselemente aus der Schiene. Dem Fachmann sind viele Ausführungsformen eines solchen Klemmmechanismus bekannt. Alternativ bevorzugt weist der Klemmmechanismus einen U-Träger-artig geformten, drehbaren Einstellbügel auf, der mit seinem Steg drehbar in Bohrungen in den Gurten des Verbindungselements aufgenommen ist. Die Flansche des U-Trägers liegen an den Außenseiten der Gurte des Verbindungselements an und sind in ihrer Form so ausgebildet, dass sie eine von ihrer Drehposition abhängige Kraft auf die Gurte ausüben. Durch diese Kraft werden die Gurte ausgelenkt und gegen die Führungsschienen verspannt.

Zusätzlich oder alternativ können die Verbindungselemente durch in Längsrichtung in die Führungsschienen einschiebbare Klemmmittel relativ zur Führungsschiene in Längsrichtung und quer zur Längsrichtung geklemmt werden. In einer beispielhaften Ausführungsform sind die Verbindungselemente nicht vollständig komplementär zur Führungsschiene ausgebildet. Nach dem Einsetzen in die Führungsschiene können die Verbindungselemente mit der Führungsschiene so einen Hohlraum einschließen, in den in Längsrichtung mindestens ein Klemmmittel eingeschoben werden kann, dass eine Verspannkraft zwischen Verbindungselement und Führungsschiene erzeugt wird.

Insgesamt kann somit erfindungsgemäß mittels den Durchgangslöchern und den am Außenumfang angebrachten Führungselementen ein Elektronikmodul in Längsrichtung als auch in Richtungen quer zur Längsrichtung dem Anwendungsfall entsprechend aufgebaut werden. In einem Spezialfall kann eine strangartige, modular aufgebaute Elektronikbaugruppe gebildet werden, die in Richtungen quer zur Längsrichtung zusätzlich "wabenartig" erweitert werden kann. In einem weiteren Spezialfall ist eine erfindungsgemäße Elektronikbaugruppe nur in Richtungen quer zur Längsrichtung hauptsächlich flächenartig ausgedehnt und kann punktuell in Längsrichtung erweitert werden.

Bei linienartigen in Längsrichtung zusammengesetzten, erfindungsgemäßen Elektronikmodulen können die auf den zweiten Platinen angeordneten Steck- und Klemm-Verbindungsmittel die elektrische Leistung sowie Kommunikationssignale zwischen den einzelnen erfindungsgemäßen Elektronikmodulen in Längsrichtung weiterleiten, und so eine geeignete elektrische, als auch kommunikative Verbindung zwischen den einzelnen Elektronikbauteilen bereitstellen, wobei die funktionellen Elektronikbauteile bevorzugt an den ersten Platinen angeordnet sind. Dass dies nicht zwingend ist, ist zumindest für den Fachmann leicht nachvollziehbar.

Bei einem "wabenartigen" Zusammensetzen erfindungsgemäßer Elektronikmodule kann eine solche Leistungsweiterleitung und/oder Kommunikationsverbindung beispielsweise über Steckbrücken zweier benachbarter Elektronikmodule bereitgestellt werden. Denkbar ist hierbei jedoch auch eine seitliche Herausführung der Steck- und Klemmverbindungsmittel an eine Außenseite des erfindungsgemäßen Gehäuses, so dass auch hier über eine einfache Steckverbindung zwischen den einzelnen Elektronikmodulen eine solche Leistungs- und/oder Kommunikationsverbindung ermöglicht wird. Auch hier ist eine kabellose Verbindung zwischen den jeweiligen Kommunikationsplatinen, d.h. den zweiten Platinen, bevorzugt, um den Aufwand, den eine elektrische und/oder elektromagnetische Abschirmung bei der Verwendung von Kabeln mit sich bringt, vermieden werden kann.

In einer weiteren Ausführungsform sind mehrere Dome und/oder Kühlrippen im Inneren der Gehäusewandung derart ausgebildet, dass zumindest eine metallische Platte im Wesentlichen quer zur Längsrichtung thermisch leitend daran angeordnet werden kann. Diese metallische Platte kann beispielsweise dafür genutzt werden, um die Wärme aus elektronischen Bauteilen, die thermisch leitend und elektrisch isoliert an der metallischen Platte angeordnet sind, abzuführen. So ist es möglich, die Wärme, die von Wärmequellen erzeugt wird, die im Inneren des Gehäuses angeordnet sind und keinen direkten Kontakt zur Gehäusewand haben, über die metallische Platte zur Gehäusewand hin abzuleiten, wo sie dann an die Umgebung abgegeben wird. Alternativ oder zusätzlich zur oben erläuterten Verwendung kann die zumindest eine metallische Platte beispielsweise der Abstützung von mechanischen Baugruppen, zum Beispiel Rotationslagern, gegen das Gehäuse bzw. gegen die Dome und/oder Kühlrippen, an denen die metallische Platte angeordnet ist, dienen. Auch dem Fachmann bekannte, hier nicht aufgeführte Einsatzmöglichkeiten einer metallischen Platte in einem Gehäuse, wie beispielsweise das Bereitstellen einer elektrischen (Erd-)Verbindung zum Gehäuse, sind vom Erfindungsgedanken umfasst.

Der Fachmann findet eine Vielzahl von Lösungen, die mindestens eine metallische Platte an den (geschlitzten) Domen und/oder Kühlrippen zu befestigen. Hierbei sind sowohl thermisch und/oder elektrisch leitende Verbindungen als auch thermisch und/oder elektrisch nichtleitende Verbindungen vom Erfindungsgedanken umfasst. So kann die metallische Platte beispielsweise mittels Schrauben, die in Gewinde, die in den ggf. geschlitzten Domen angeordnet sind, gedreht werden, oder mittels Kleben, mittels Schweißen, oder mittels Klemmen befestigt werden.

In einer anderen Ausführungsform können zwei metallische Platten benutzt werden, um mindestens einen Akkumulator bzw. ein Akkumulator Pack im Gehäuse festzulegen. Dafür werden die zwei metallischen Platten so in Längsrichtung an voneinander entfernten Domen und/oder Kühlrippen befestigt, dass sie den oder die im Inneren der Gehäusewandung zwischen den beiden Platten festzulegenden Akkupacks einschließen. Das zumindest eine eingeschlossene Akkupack kann beispielsweise dadurch festgelegt sein, dass es im Vergleich zum Längsabstand der beiden metallischen Platten ein kleines Übermaß in Längsrichtung aufweist und dann durch die beim Befestigen der metallischen Platten an den Domen und/oder Kühlrippen entstehende Vorspannkraft in seiner Position gehalten wird.

In einer weiteren Ausgestaltung dieser Ausführungsform können die von metallischen Platten geklemmten Akkumulator Packs auch quer zur Längsrichtung im Gehäuse mit Hilfsmitteln festgesetzt werden. Diese Hilfsmittel können zum Beispiel ein Aufquellen der Akkumulatoren in Längs- und/oder Querrichtung verhindern und ggf. die von den Akkumulatoren erzeugte Wärme zur Gehäusewand leiten. Neben vielen anderen Möglichkeiten ist dem Fachmann beispielsweise die Benutzung von Keilen, Vergussmaterial oder Schaummaterial zur Festsetzung der Ackumulatoren bekannt. Wenn mechanische Mittel zum Festsetzen der Akkumulatoren verwendet werden, ist es weiterhin vom Erfindungsgedanken umfasst, diese Mittel einstellbar zu gestalten. So kann der Anpressdruck auf die Akkumulatoren bei der Erstmontage genau eingestellt werden und auch im Betrieb immer wieder nachjustiert werden. In einer beispielhaften Ausgestaltung der Erfindung können Einstellschrauben 67 vorgesehen sein, die sich an den metallischen Platten abstützen und eine mit zunehmender Einschraubtiefe wachsende Verspannkraft auf die Akkumulatoren bereitstellen.

In einer beispielhaften Ausführungsform der Erfindung werden mehrere Elektronikmodule, die Akkumulatoren Packs enthalten, über die Steck- und/oder Klemmverbindungsmittel auf zweiten Platinen in Reihe geschaltet und bilden so eine Akku-Elektronikmodulbaugruppe. Die Gesamtspannung, die von der Akku-Elektronikmodulbaugruppe bereitgestellt werden kann, entspricht bei einer Reihenschaltung der Summe der Spannungen der einzelnen Elektronikmodule. Somit können durch die Hintereinanderschaltung von mehreren Elektronikmodulen beliebig hohe Spannungen erreicht werden.

Zur Erhöhung der Sicherheit beim Umgang mit einer solchen Akku-Elektronikmodulbaugruppe oder anderen Elektronikmodulbaugruppen, die hohe Spannung und/oder Ströme führende Elektronikbauteile enthalten, können konstruktive Zusatzmaßnahmen vorgesehen sein, die verhindern, dass Benutzer einer solchen Elektronikmodulbaugruppe zu Schaden kommen. So muss beispielsweise bei der Demontage einer solchen zusammengesteckten Elektronikmodulbaugruppe dafür gesorgt werden, dass an den berührbaren Steck- und/oder Klemmverbindungsmitteln, die elektrische Leistung aus der Elektronikmodulbaugruppe nach außen übertragen können, keine für den Benutzer gefährliche Spannung anliegt.

Ein möglicher Lösungsansatz, um gefährliche Spannungen an nicht berührsicheren Steck- und/oder Klemmverbindungsmitteln zu vermeiden, ist es, die Hintereinanderschaltung von mehreren Energiespeichern in einer Elektronikmodulbaugruppe im ersten Schritt einer Demontage an einer unkritischen Stelle aufzutrennen, sodass nach dem Trennen die Reihenschaltung unterbrochen ist. Zur Vorgabe der Zusammenbau- und/oder Trennreihenfolge kann das erfindungsgemäße Elektronikmodul mit einem Sicherheitsmechanismus ausgestattet sein, der die Montage- und/oder Demontagereihenfolge vorgibt. Vom Erfindungsgedanken ist umfasst, sowohl eine Verbindung in Längsrichtung als auch eine Verbindung in Querrichtung mit einem derartigen Sicherheitsmechanismus zu sichern. Dem Fachmann sind hierfür viele Lösungen bekannt, beispielsweise das Hinzufügen von Klemmmitteln, die nur in einer bestimmten Reihenfolge gelöst werden können.

Ein bevorzugtes Mittel, die Montage- und Demontagereihenfolge von mehreren in Längsrichtung angeordneten Modulen vorzugeben, sind Schrauben, die von dem nächsten in Längsrichtung angeordneten Modul überdeckt werden. So kann nur das in Längsrichtung äußerste Modul mit dem ihm benachbarten Modul verschraubt werden, wobei andere Schraubverbindungen zwischen Modulen verdeckt sind. In dieser Ausgestaltung der Erfindung kann eine Reihenschaltung einer Akku-Elektronikmodulbaugruppe so ausgeführt sein. Bevorzugt wird beim Abnehmen des in Längsrichtung äußersten Moduls die Reihenschaltung zwischen den Modulen unterbrochen und es liegt keine für den Benutzer gefährliche Spannung mehr an den Klemmen des demontierten Elektronikmoduls und/oder des/der verbleibenden Elektronikmodule an.

Als weitere Möglichkeit, einen sicheren Umgang mit den Elektronikmodulen zu ermöglichen, ist in einer beispielhaften Ausgestaltung der Erfindung vorgesehen, die nicht berührgeschützten, spannungsführenden Verbindungsmittel durch eine verschiebliche Abdeckplatte gegen Berührung zu schützen. Die Abdeckplatte wird von einem vorzugsweise mechanischen Rückstellmechanismus über dem Stecker positioniert. Wenn das Elektronikmodul, das den mechanischen Rückstellmechanismus aufweist, direkt in Längsrichtung hinter einem anderen Elektronikmodul angeordnet wird und ein Berühren des spannungsführenden Verbindungsmittels nicht mehr möglich ist, wird eine dem Rückstellmechanismus entgegenwirkende Kraft erzeugt, die die Abdeckung so verschiebt, dass das Verbindungsmittel des einen Elektronikmoduls das Verbindungsmittel des anderen Elektronikmoduls kontaktieren kann.

Des Weiteren ist es im Sinne einer anderen beispielhaften Ausgestaltung der Erfindung vorgesehen, die spannungsführenden, nicht berührgeschützten Verbindungsmittel auf einer verschieblichen Platine anzuordnen, wobei ein Rückstellmechanismus an der verschieblichen Platine vorgesehen ist. Dieser stellt nur dann eine stromleitende Verbindung zwischen dem nicht berührgeschützten Verbindungsmittel und anderen elektrischen Bauteilen her, wenn das Elektronikmodul, in dem das nicht berührgeschützte Verbindungsmittel angeordnet ist, so in Längsrichtung hinter einem anderen Elektronikmodul angeordnet ist, dass ein Berühren des Verbindungsmittels nicht mehr möglich ist.

In einigen Anwendungsfällen, beispielsweise für die Verwendung erfindungsgemäßer Elektronikmodule bei der Umwandlung regenerativer Energien, können die einzelnen Elektronikmodule beispielsweise in Längsrichtung eines mechanischen Antriebsstranges angeordnet werden, so dass beispielsweise ein seitlicher Bauraum klein gehalten werden kann. Hierbei ist es weiterhin vorstellbar, dass auch Generatorbauteile, wie beispielsweise eine Statorbaugruppe und eine Rotorbaugruppe, innerhalb eines erfindungsgemäßen Elektronikmoduls aufgenommen werden. Die Rotorwelle der Rotorbaugruppe kann beispielsweise in Rotationslagern, die in metallischen Platten eingebracht sind, gelagert werden. Für einen Fachmann sind aber auch andere Möglichkeiten der Lagerung der Rotationswelle denkbar, beispielsweise die Einbringung der Rotationslager in einen Gehäusedeckel. Es ist vom Erfindungsgedanken umfasst, dass der Rotor der elektrischen Maschine aus mehreren Rotorunterbaugruppen aufgebaut ist. Genauso ist es im Sinne der Erfindung, den Stator aus mehreren Statorunterbaugruppen aufzubauen.

In einer erfindungsgemäßen Ausgestaltung eines Elektronikmoduls mit elektrischer Maschine kann ein Ende der Rotorwelle oder ein Adapterstück, das die Rotorwelle verlängert, über die Stirnseite des Gehäuses vorstehen. Dies ermöglicht es, die Rotorwelle des Elektronikmoduls mit einer anderen mechanischen Baugruppe in Verbindung zu bringen. Unter anderen mechanischen Baugruppen werden im Sinne der Erfindung sowohl andere mechanische Baugruppen, die in weiteren Elektronikmodulen angeordnet sind, verstanden, beispielsweise in einem Elektronikmodul montierte Getriebeeinheiten, als auch andere mechanische Baugruppen, die nicht Teil eines weiteren Elektronikmoduls sind, beispielsweise eine Adaptervorrichtung für ein Windrad zum Antreiben der elektrischen Maschine.

Zum Festsetzen einer Statorbaugruppe im Gehäuse eines Elektronikmoduls sind dem Fachmann verschiedene Möglichkeiten geläufig, beispielsweise Anschrauben oder Ankleben, etc. Im Sinne der Erfindung ist jedoch unter anderem bevorzugt, die Statorbaugruppe in das Gehäuse thermisch einzupressen. Hierfür wird das Gehäuse des Elektronikmoduls vorgewärmt, wobei sich der Gehäuseinnenraum durch die Wärmeausdehnung des Gehäusematerials vergrößert. Nach dem darauffolgenden Einsetzen der Statorbaugruppe in den Gehäuseinnenraum verkleinert sich beim anschließenden Abkühlprozess der Gehäuseinnenraum wieder, wodurch eine, mit fortschreitender Abkühlung steigende, über den Umfang des Gehäuses verteilte, nach innen gerichtete Kraft auf die Statorbaugruppe erzeugt wird, die die Statorbaugruppe in ihrer Position festsetzt.

Bei einem erfindungsgemäßen Elektronikmodul mit einer Elektromaschine kann entweder die Rotorwelle oder eine mit der Rotorwelle drehfest verbundene Verlängerungswelle mit einem ersten Ende über eine Stirnseite des Gehäuses vorstehen, wobei dem Fachmann zahlreiche Möglichkeiten bekannt sind, eine drehfeste Verbindung zwischen zwei Wellen herzustellen, beispielsweise Flansch oder Keilwellenverbindungen. Über das vorstehende, erste Ende der Welle kann beispielsweise ein An- oder Abtriebsmoment übertragen werden oder das erste Ende der Rotorwelle kann mit dem zweiten Ende der Rotorwelle eines weiteren, in Längsrichtung koaxial angeordneten Elektronikmoduls in drehfestem Eingriff stehen.

Zur Weiterleitung oder weiteren Umwandlung der aus einem Elektronikmodul mit elektrischer Maschine gewonnenen elektrischen Energie kann es erforderlich sein, eine zweites Elektronikmodul, das erste und/oder zweite Platinen aufweist, an das erste Elektronikmodul, das eine Elektromaschine aufweist, über zweite Platinen anzuschließen und so eine Elektronikmodulbaugruppe aufzubauen. Wenn aus dem ersten Modul eine Rotorwelle vorsteht, so ist das erste Elektronikmodul so angeordnet, dass das vorstehende Ende der Rotorwelle vom zweiten Elektronikmodul weg zeigt. Die beiden Elektronikmodule können mittels zweiter Platinen kabellos mittels Steck und/oder Klemmverbindungen miteinander verbunden werden. So können Leistungs- und/oder Kommunikationssignale von der Motorbaugruppe an die elektronischen Bauteile auf der ersten Platine des zweiten Elektronikmoduls weitergeleitet werden.

In einer weiteren Ausgestaltung der Erfindung kann das vorstehende Ende der Rotorwelle eines ersten Elektronikmoduls mit der Rotorwelle eines weiteren Elektronikmoduls in drehfestem Eingriff stehen. Die axiale Position der Rotorwellen kann beispielsweise durch die Positionierung der Gehäuse zueinander festgelegt werden, wobei die Rotorwellen mittels Lager in den jeweiligen Gehäusen festsetzbar sind. So ist es möglich mehrere Elektronikmodule mit elektrischen Maschinen hintereinanderzuschalten, beispielsweise um die bei gleicher Drehzahl der Rotorwelle abrufbare elektrische Leistung zu erhöhen.

Auch ist es in einer weiteren erfindungsgemäßen Variante denkbar, eine Elektronikmodulbaugruppe, die aus mindestens einem Elektronikmodul mit elektrischer Maschine und einem anderen Elektronikmodul mit elektrischen Komponenten besteht, mit weiteren Elektronikmodulen, die die elektronischen Komponenten enthalten, zu erweitern. So kann beispielsweise an ein Generator-Elektronikmodul ein Gleichrichter-Elektronikmodul und daran ein Akkumulator-Elektronikmodul gereiht werden. So könnte der im Generator erzeugte Wechselstrom zunächst gleichgerichtet werden und dann in den Akkumulatoren gespeichert werden. Der Fachmann erkennt hierbei, dass eine Vielzahl an Kombinationen und Reihenfolgen von hintereinander angeordneten Elektronikmodulen möglich ist, die alle vom Erfindungsgedanken umfasst sind.

Vereinzelt kann es in einer Elektronikmodulbaugruppe bevorzugt sein, Leistungs- und/oder Kommunikationssignale zwischen den Rotorbaugruppen, Rotorunterbaugruppen, Statorbaugruppen und/oder Statorunterbaugruppen und den ersten Platinen bzw. Elektronikbauteilen mittels Kabel zu übertragen. Dies kann vor allem in langen Elektronikmodulbaugruppen mit vielen elektrische Maschinen und vielen dazugehörigen Wandler-Elektroniken auftreten, da die Leistungs- und Kommunikationssignale dann zu zahlreich sein können, um alle über eine zweite Platine transportiert zu werden.

Weiterhin kann die in einem Elektronikmodul mit einer elektrischen Maschine erzeugte elektrische Energie über eine erste und eine zweite Platine mittels der Steck- und/oder Klemm-Verbindungsmittel an weitere erfindungsgemäße Elektronikmodule weitergeleitet werden. In einem solchen weiteren, dem Generator nachgeschalteten, erfindungsgemäßen Elektronikmodul kann beispielsweise die als Gleichstrom erzeugte elektrische Energie mittels eines DC/DC-Wandlers in seiner Spannungshöhe und Stromstärke gewandelt werden und/oder mittels eines DC/AC-Wandlers in Wechselstrom umgewandelt werden. Der Fachmann erkennt hierbei, dass eine Kombination oder Reihenfolge verschiedener Wandler vom Erfindungsgedanken umfasst ist.

Das zuvor beschriebene Elektronikmodul mit einem darin aufgenommenen Generator stellt beispielsweise ein in Längsrichtung eines Elektronikmodul-Stranges anordenbares Abschlusselement dar. Selbstredend kann ein solches Abschlusselement als einfacher Deckel ausgeführt sein, der bevorzugt eine Stirnseite eines erfindungsgemäßen Elektronikmoduls staub- und/oder fluiddicht verschließt. Dabei sind Abschlusselemente, die mehrere seitlich nebeneinander angeordnete erfindungsgemäße Elektronikmodul gleichzeitig verschließen, ebenso vom Erfindungsgedanken umfasst, wie die Rückwand eines Schaltschrankes.

In den folgenden Figuren sind beispielhafte Ausführungsformen des erfindungsgemäßen Elektronikmoduls gezeigt, die jedoch lediglich der Verdeutlichung des Erfindungsgedankens dienen. Die in den Figuren dargestellten beispielhaften Ausführungsformen begrenzen den Schutzbereich der vorliegenden Erfindung nicht. Dem Fachmann naheliegende Abwandlungen oder Modifikationen der zuvor allgemein und nachfolgend beispielhaft beschriebenen Ausführungsformen sind daher ebenso vom Schutzumfang der Erfindung umfasst. Es zeigen:
- Figur 1: ein erstes Ausführungsbeispiel eines erfindungsgemäßen Elektronikmoduls mit aufgebrochenem Gehäuse;
- Figur 2: ein zweites Ausführungsbeispiel eines erfindungsgemäßen Elektronikmoduls mit aufgebrochenem Gehäuse und einem Sicherheitsmechanismus;
- Figur 3: eine Schnittdarstellung eines erfindungsgemäßen Elektronikmoduls in einer zweiten Ausführungsform;
- Figur 4: eine weitere Ausführungsform des erfindungsgemäßen Elektronikmoduls in einem vormontierten Zustand;
- Figur 5: das in Figur 4 gezeigte Ausführungsbeispiel im montierten Zustand in einer Schnittdarstellung;
- Figur 6: eine Ausschnittsvergrößerung einer weiteren beispielhaften Ausführungsform des erfindungsgemäßen Elektronikmoduls in einem vormontierten Zustand;
- Figur 7: ein weiteres Ausführungsbeispiel des erfindungsgemäßen Elektronikmoduls in einer perspektivischen Darstellung;
- Figur 8: ein Anwendungsbeispiel für ein erfindungsgemäßes Elektronikmodul;
- Figur 9: eine beispielhafte Ausführung eines erfindungsgemäßen Elektronikmoduls mit einer vorgegebenen Montage-/Demontagereihenfolge;
- Figur 10: eine Ausführungsform eines erfindungsgemäßen Elektronikmoduls mit einer Kombinationskodierung;
- Figur 11: eine beispielhafte Anordnung von mehreren beispielhaften erfindungsgemäßen Elektronikmodulen in Längsrichtung;
- Figur 12: eine beispielhafte Anordnung von mehreren beispielhaften erfindungsgemäßen Elektronikmodulen quer zur Längsrichtung;

Nachfolgend werden die in den Figuren dargestellten Ausführungsbeispiele beispielhaft im Detail erläutert, wobei für gleiche bzw. ähnliche Bauteile mit gleicher Wirkung die Bezugszeichen beibehalten werden.

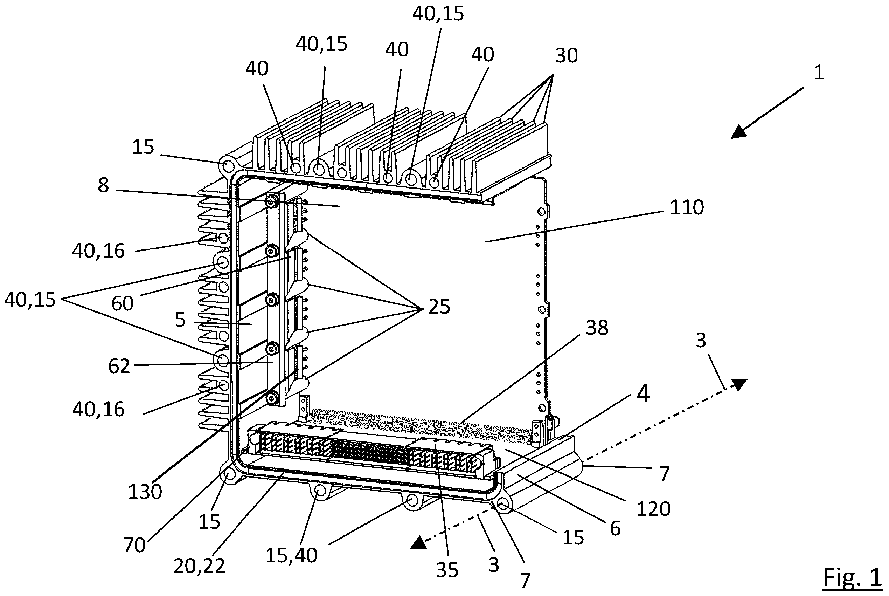

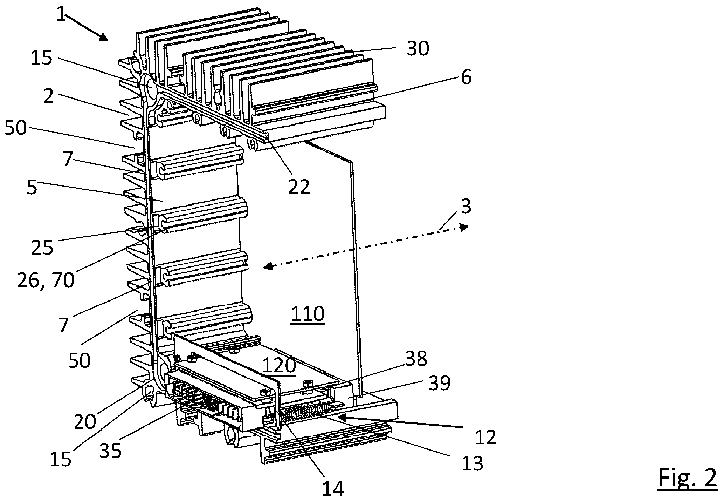

Figur 1 zeigt ein erfindungsgemäßes Elektronikmodul 1 mit einem Gehäuse 2, das in einem Seitenbereich aufgebrochen dargestellt ist. Hierbei ist erkennbar, dass eine Gehäusewandung 4 durch jeweils eine Stirnseite 7 in einer Längsrichtung 3 begrenzt ist, wobei jede Stirnseite 7 eine Öffnung 8 umgibt. Über die Öffnungen 8 kann - wie in Figur 1 dargestellt - zumindest eine erste Platine 110 in das Gehäuse 2 quer zur Längsrichtung 3 eingesetzt werden. Parallel zur Längsrichtung 3 kann zumindest eine zweite Platine 120 in Aufnahmenuten 70 (siehe auch Figur 2) eingeschoben werden. Die beiden Platinen 110 und 120 sind mittels einer Steckverbindung 38 innerhalb des Gehäuses 2 zum Weiterleiten von elektrischer Leistung und Kommunikationssignale miteinander verbunden. In Längsrichtung 3 ist die Position der ersten Platine 110 über Dome 25 festgelegt, an die die Platine 110 beispielsweise angeschraubt werden kann. Somit ist auch die Position der zweiten Platine 120 in Längsrichtung festgelegt, da diese über die Steckverbindung bzw. Klemmverbindung 38 mit der ersten Platine 110 verbunden ist. Auf der zweiten Platine 120 sind weitere Steck- und/oder Klemmverbindungsmittel 35 angeordnet, mit denen eine kabellose Verbindung zu einem benachbarten, erfindungsgemäßen Elektronikmodul 1 hergestellt werden kann. Sowohl die zumindest eine erste Platine 110 als auch die zumindest eine zweite Platine 120 können je nach Anwendungsfall für erfindungsgemäße Elektronikmodule 1 bedarfsgerecht mit weiteren Elektronikbauteilen 100, wie beispielsweise Halbleitermodulen, Widerständen, Kondensatoren, Frequenzumrichter, Spannungswandlern, usw. bestückt sein, die für die jeweilige Anwendung benötigt werden.

Über die Steckverbindung 38 zwischen der ersten Platine 110, welche im Allgemeinen die Platine ist, auf der die Funktionselektronik angeordnet ist, mit der zweiten Platine 120, welche im Allgemeinen die Verbindungsplatine zum Weiterleiten von elektrischer Leistung und Kommunikationssignale darstellt, ist eine aufwendige Verbindung von Abschirmungen für die elektrischen Leitungen, wie sie bei der Verwendung von Kabelverbindungen notwendig ist, nicht erforderlich, da im Aufbau von Platinen solche Abschirmungen fachüblich integriert werden können. Ein Analoges gilt für die Verbindung benachbarter erfindungsgemäßer Elektronikmodule 1 für die auf der zweiten Platine angeordneten 110 Steck- und/oder Klemmverbindungsmittel 35, die daher ein einfaches Zusammenstecken der Elektronikmodule 1 erlauben.

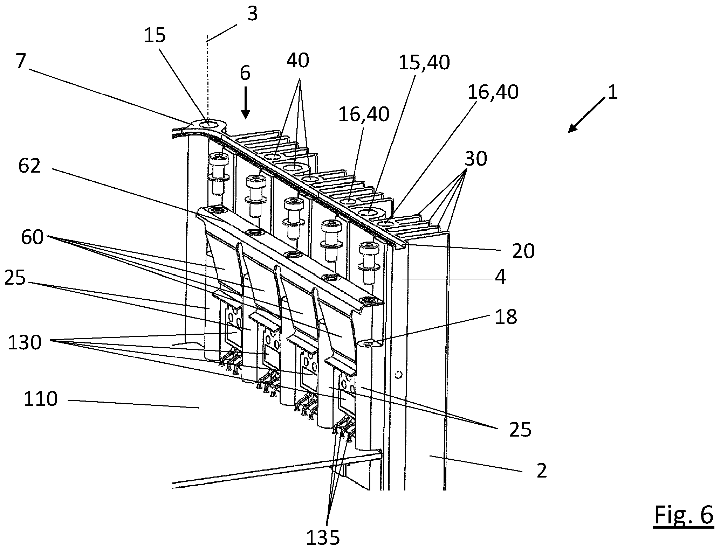

An der in der Figur 1 linken Gehäuseinnenseite 5 erkennt man eine Mehrzahl von Domen 25, mittels derer die Funktionsplatine, d.h. die erste Platine 110, in ihrer Position in Längsrichtung 3 arretiert ist. Zum Variieren der Position der ersten Platine 110 können die Dome 25 in ihrer Länge bzw. Höhe in Längsrichtung 3 geeignet angepasst werden, beispielsweise durch ein spanabnehmendes und/oder ein anderes Material-abnehmendes Verfahren. Des Weiteren können die Dome 25 von der anderen Seite - wie in Figur 1 dargestellt - ebenfalls bearbeitet werden und ihrer Länge angepasst werden, so dass beispielsweise eine Klemmleiste 62 zum Fixieren von Elektronikbauteilen 130 daran befestigbar ist (s. hierzu im Detail Figur 6 mit zugehöriger Beschreibung).

Figur 2 zeigt einen Schnitt durch eine andere beispielhafte Ausführungsform eines Elektronikmoduls 1 mit einem Gehäuse 2, an dessen Gehäuseaußenseite 6 Kühlrippen 30 angeordnet sind. In dieser beispielhaften Ausführungsform des Elektronikmoduls 1 sind an den Domen 25, die an der Gehäuseinnenseite 5 angeordnet sind, Schlitze 26 bzw. Aufnahmenuten 70 angeordnet. Diese können der Aufnahme von ersten und/oder zweiten Platinen 110, 120 in Längsrichtung 3 dienen. An den in Längsrichtung 3 angeordneten Platinen 110, 120 sind Klemm- und/oder Steckverbindungsmittel 35 vorgesehen, die das Herstellen einer elektrischen Verbindung zwischen mehreren hintereinander in Längsrichtung 3 angeordneten Platinen 110, 120 und zu quer in Längsrichtung 3 angeordneten Platinen 110, 120 und/oder zwischen in Längsrichtung 3 angeordneten Platinen 110, 120 weiterer Elektronikmodule 1 ermöglichen.

Im unteren der Teil des Gehäuses 2 ist eine beispielhafte Ausführungsform einer Sicherheitsvorrichtung 12 angeordnet. Die zweite Platine 120 des abgebildeten Elektronikmoduls 1 ist in Längsrichtung 3 beweglich angeordnet. In einer Ausgangsposition liegt die zweite Platine 120 an einem Anschlag 14 an und ist zu einem Gehäuseäußeren hin verschoben. Eine Zugfeder 13 hält die Platine 120 in dieser Position und ist in dieser Lage beispielsweise entspannt, wobei eine Steckverbindung 38 zwischen der verschieblichen zweiten Platine 120 und einer gehäusefesten, quer zur Längsrichtung angeordneten beispielsweise ersten Platine 110 nicht hergestellt ist. Der in Längsrichtung angeordnete Steckverbinder 35 für die externe Leistungs- und Kommunikationsverbindung des Elektronikmoduls 1 steht in dieser gezeigten Ausgangsposition über die Stirnseite 7 des Elektronikmoduls 1 vor.

Wird das eben beschriebenen Elektronikmodul 1 mit der Stirnseite 7, auf welcher der Steckverbinder 35 vorsteht, mit einem weiteren Elektronikmodul 1 oder einer Elektronikmodulbaugruppe verbunden, so wird die Platine 120 in Richtung Gehäuseinneres verschoben und stellt über eine elektrisch leitende Steckverbindung 38 mit der zu ihm komplementären Buchse 39 eine elektrisch leitende Verbindung zwischen der Platine 120 und der Platine 110 her. Gleichzeitig wird eine elektrische Verbindung über die Steckverbindungmittel 35 mit dem angrenzenden Elektronikmodul 1 hergestellt. Die Buchse 39 ist beispielsweise auf einer gehäusefesten ersten Platine 110 angeordnet. Sobald der Steckverbinder 38 und die Buchse 39 sich berühren, ist die Feder 13 gespannt und übt eine Rückstellkraft auf die verschiebliche Platine 120 aus. Somit wird insgesamt eine leitende Verbindung zwischen der im ersten Gehäuse 2 angeordneten ersten Platine 110 und der im zweiten Gehäuse 2 - hier verschieblich - angeordneten zweiten Platine 120, hergestellt.

Werden die beiden Gehäuse 2 voneinander getrennt, so zieht die Rückstellkraft der gespannten Feder 13 die Platine 120 wieder in Richtung Gehäuseäußeres und unterbricht somit die elektronische Verbindung zwischen Steckverbindung 38 auf der zweiten Platine 120 und der Buchse 39 auf der Platine 110. Der aus dem ersten Gehäuse 2 vorstehende Steckverbinder 35 ist dann spannungsfrei und kann von einem Monteur gefahrlos berührt werden.

In den in den Figuren 1 und 2 dargestellten Ausführungsbeispielen sind die Dome 25 beispielsweise mit einem Gewinde versehen, nachdem sie zuvor in ihrer Länge angepasst wurden, womit eine Klemmleiste 62 analog zum Ausführungsbeispiel der Figur 1 in Längsrichtung 3 auf/an den Domen 25 mittels Schrauben befestigbar ist. Über die Klemmleiste 62 werden Klammern 60 in Zwischenräumen zwischen den Domen 25 derart fixiert, dass die Klammer 60 Elektronikbauteile 130 gegen die Innenseite 5 der Gehäusewandung 4 drücken kann. Auf der entsprechenden Außenseite 6 der Gehäusewandung 4 sind Kühlrippen 30 vorgesehen, um die Wärme, die im Betrieb der Elektronikteile 130 entsteht, ableiten und an die Umgebung abgeben zu können.

In dem Ausführungsbeispiel der Figur 1 sind zusätzlich Flüssigkeitskanäle 40 an Außenseite 6 der Gehäusewandung 4 im Bereich der Elektronikbauteile 130 angeordnet, die zumindest teilweise in die Kühlrippen 30 integriert sind und die Kühlleistung der Kühlrippen 30 bzw. des Gehäuses 2 verstärken. Zwischen den Kühlrippen 30 sind ferner Durchgangslöcher 15 angeordnet, die zum Verbinden mehrerer erfindungsgemäßer Elektronikmodule 1 verwendet werden können. Dabei können auch diese Durchgangslöcher 15 als Flüssigkeitskanäle 40 verwendet werden. Somit bleibt es dem Verwender des erfindungsgemäßen Elektronikmoduls überlassen, ob die Durchgangslöcher 15 zum Verbinden zweier oder mehrerer Gehäuse 2 verwendet werden sollen oder ob diese als Flüssigkeitskanäle 40 zum Weiterleiten von Kühlflüssigkeit entlang der Gehäusewandung 4 verwendet werden sollen. In Figur 1 sind an weiteren Seiten der Gehäusewandung 4 weitere Flüssigkeitskanäle 40 für die Weiterleitung von Kühlflüssigkeit gezeigt, wodurch beispielsweise verschieden temperierte oder Gegenstrom-Kühlkreisläufe ausgestaltet werden können.

Im Ausführungsbeispiel der Figur 2 sind der Übersichtlichkeit halber keine Klammern 60 bzw. Klemmleisten 62 an den mit Schlitzen 26 versehenen Domen 25 befestigt. Trotzdem liegt es im Bereich des fachmännischen Könnens auch an diesen geschlitzten Domen 25 Klammern 60 bzw. Klemmleisten 62 zu befestigen, beispielsweise mittels Eindrehen einer Schraube in ein in dem Dom 25 eingebrachtes Gewinde.

Die in den Figuren 1 und 2 dargestellten Elektronikmodule 1 zeigen im unteren Bereich eine weitere Besonderheit. Dort sind keine Kühlrippen angeordnet, womit dieser seitliche Bauraum des erfindungsgemäßen Elektronikmoduls kleingehalten werden kann und/oder eine Aufstandsfläche bereitgestellt werden kann. Dies gilt allgemein für alle erfindungsgemäßen Gehäuse 2, da nicht an allen Seitenflächen temperatursensible Elektronik angeordnet sein muss, speziell nicht an Seitenflächen benachbart zur zweiten Platine 120, wodurch Kühlrippen und/oder Kühlkanäle nicht benötigt werden. Anstatt dessen können an diesen Seitenflächen beispielsweise auch Führungsschienen 50 und/oder Führungssteine 55 angeordnet sein, um ein seitliches Verbinden zweier Gehäuse 2 der erfindungsgemäßen Elektronikmodule 1 zu ermöglichen. Auch können an diesen beispielsweise kühlrippenfreien Außenseiten weitere Steck- und/oder Klemm-Verbindungsmittel 35 zur Weiterleitung von elektrischer Leistung und Kommunikationssignale zwischen seitlich benachbarten erfindungsgemäßen Elektronikmodulen 1 angeordnet sein.

Zum Verbinden zweier Gehäuse 2 erfindungsgemäßer Elektronikmodule 1 beispielsweise über die Durchgangslöcher 15 können zum Abdichten zweier Gehäuse 2 Dichtflächen 22 bzw. Dichtkonturen 20 an den Stirnseiten 7 vorgesehen sein, damit eine staub- und/oder wasserdichte Verbindung zweier in Längsrichtung 3 verbundener Gehäuse 2 bereitgestellt werden kann. In eine solche Dichtkontur 20 kann beispielsweise eine Ringdichtung eingelegt werden, welche mit einer Dichtkontur 20 eines weiteren Gehäuses 2 zusammenwirkt. Eine solche Abdichtung zwischen zwei Bauteilen über eine Dichtfläche 22 oder eine Dichtkontur 20 ist dem Fachmann geläufig, so dass alle fachüblichen Variationen zum Erzielen einer Staub- und/oder Flüssigkeitsdichtung vom Erfindungsgedanken umfasst sind.

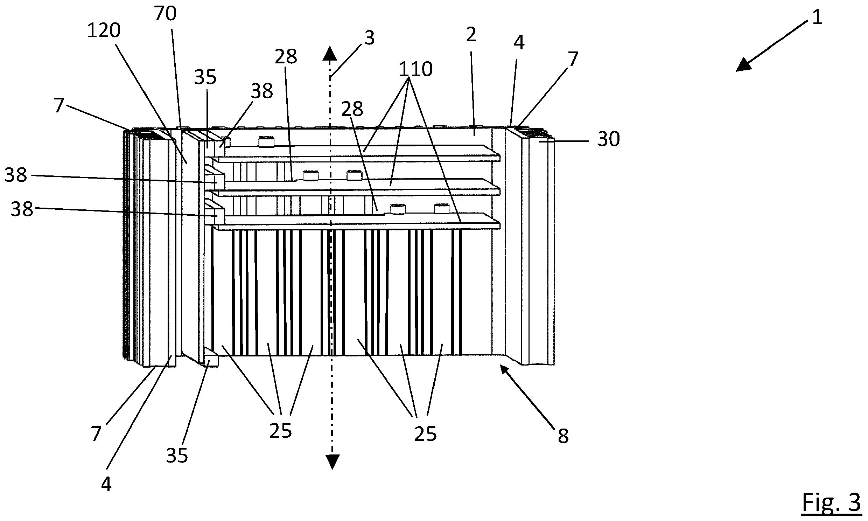

In Figur 3 ist eine Schnittdarstellung eines weiteren Ausführungsbeispiels des erfindungsgemäßen Elektronikmoduls 1 dargestellt. Das Gehäuse 2 ist in Längsrichtung 3 jeweils durch eine Stirnfläche 7 in seiner Höhe bzw. Länge begrenzt. Dabei weisen die Stirnseiten 7 Öffnungen 8 auf, durch die das Gehäuse 2 mit Elektronikbauteilen 100 bestückt werden kann. Bei dem in Figur 3 dargestellten in Längsrichtung 3 aufgeschnittenen erfindungsgemäßen Elektronikmodul 1 sind drei erste Platinen 110 parallel zueinander angeordnet und mit einer zweiten Platine 120 verbunden, bevorzugt über Steckverbindungen 38. Über diese Steckverbindungen 38 können elektrische Leistung und/oder Kommunikationssignale zwischen den ersten Platinen 110 (Funktionsplatinen) und der zweiten Platine 120 (Verbindungsplatine) weitergeleitet bzw. ausgetauscht werden.

Die in Figur 3 dargestellte parallele Anordnung mehrerer erster Platinen 110 wird beispielsweise dadurch ermöglicht, dass die Dome 25 auf einer Seite in unterschiedlicher Höhe in Längsrichtung 3 angepasst sind, so dass Ausnehmungen 28 in den Platinen 110 es ermöglichen, dass die Platinen 110 an den Domen 25, die für die Befestigung einer anderen ersten Platine 110 vorgesehen sind, vorbei geschoben werden können. Dies ist mit den unterschiedlich hohen Paaren von Domen 25 in Figur 2 anschaulich gezeigt. Ein Fachmann erkennt, dass die seitliche Anordnung der Dome 25 auch anders gewählt werden kann, so dass die einzelnen Anschraubpunkte für jede einzelne erste Platine 110 beispielsweise weiter voneinander beabstandet sind. Weiter erkennt man aus Figur 3, dass die Dome 25 an den Seiten (hier die Unterseite), an denen keine erste Platine 110 befestigt ist, unbearbeitet sind und somit an der entsprechenden Stirnseite 7 enden. Dies ergibt sich daraus, dass das Gehäuse 2 bevorzugt in einem Endlosstrangpress- oder Stranggießverfahren oder im Extrudierverfahren hergestellt wird und modular in Abschnitte aufgeteilt wird.

Im Weiteren entspricht das Gehäuse 2, das in Figur 3 dargestellt ist, den Gehäusen 2, welche in den Figuren 1 und 2 gezeigt sind, wobei man an den Außenseiten 6 der Gehäusewandung 4 Kühlrippen 30 erkennen kann, die für die Kühlung der im Gehäuse 2 aufgenommenen Elektronikbauteile 100 vorgesehen sind. Die in Figur 3 dargestellte zweite Platine 120 verläuft von einer Stirnseite 7 zur gegenüberliegenden Stirnseite 7 und weist an ihren jeweiligen Enden Steck- und/oder Klemm-Verbindungsmittel 35 auf, an denen eine weitere zweite Platine 120 eines weiteren erfindungsgemäßen Elektronikmoduls 1 kabellos angebunden werden kann. Diese zweite Platine 120 ist in diesem Ausführungsbeispiel in Aufnahmenuten 70, die im Gehäuse 2 in Längsrichtung 3 ausgebildet sind, aufgenommen. Der Fachmann erkennt, dass diese Aufnahmenuten auch als Schlitze 26 in den Domen 25 ausgeführt sein können.

Aus dem in Figur 3 dargestellten Ausführungsbeispiel entnimmt man weiter, dass beispielsweise für die variable Positionierung nur einer einzigen ersten Platine 110 in Längsrichtung 3 innerhalb des Gehäuses 2 es lediglich einer geeigneten Bearbeitung/Kürzung der Dome 25 bedarf, damit die erste Platine 110 den jeweiligen Anforderungen angepasst, in das Gehäuse eingesetzt werden kann. Dabei verläuft die mit der ersten Platine 110 steckverbundene, zweite Platine 120 jeweils von einer Stirnseite 7 zur gegenüberliegenden Stirnseite 7 und stellt dort jeweils Steck- und/oder Klemm-Verbindungsmittel 35 bereit, die zum Anbinden weiterer erfindungsgemäßer Elektronikmodule 1 vorgesehen sind.

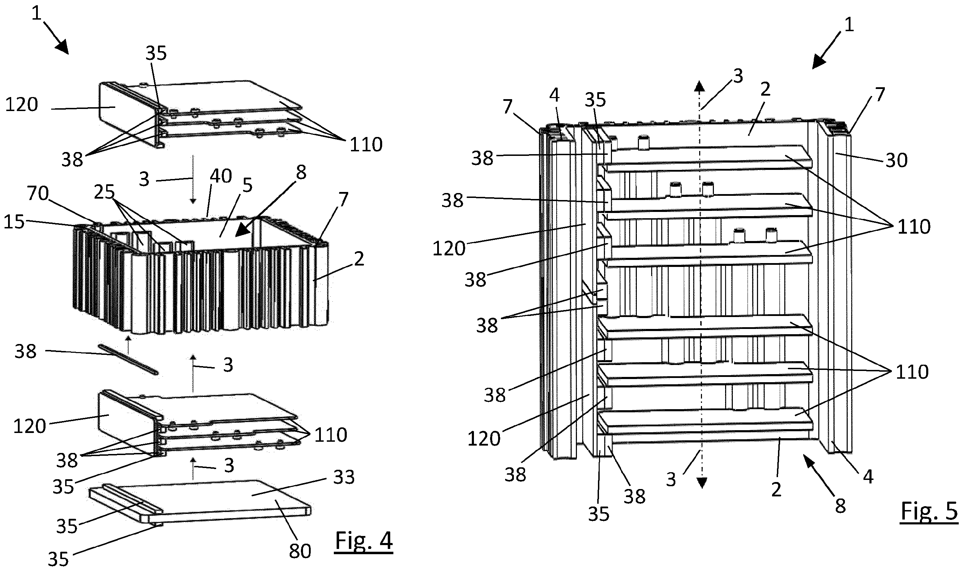

Figur 4 und Figur 5 zeigen eine weitere beispielhafte Ausführungsform des erfindungsgemäßen Elektronikmoduls 1, bei dem eine Vielzahl von ersten Platinen 110 parallel zueinander im Gehäuse 2 angeordnet sind. Hierbei zeigt Figur 4 zwei Vormontagegruppen, welche jeweils drei erste Platinen 110 mit einer damit verbundenen zweiten Platine 120 zeigt. Die Vormontagegruppen können von beiden Stirnseiten jeweils über die jeweilige Öffnung 8 in das Gehäuse 2 eingesetzt werden. Hierbei entspricht die Montagerichtung der Längsrichtung 3, welche in Figur 4 mit aufeinander zu weisenden Pfeilen dargestellt ist. Die Montagerichtung entspricht dabei ebenfalls der Formungs- bzw. Entformungsrichtung bei der Herstellung der Gehäuse 2. In die Gehäusewandung ist neben den Domen 25 eine Aufnahmenut 70 in Längsrichtung 3 des Gehäuses 2 angeordnet, in welche die beiden zweiten Platinen 120 mit den daran verbundenen ersten Platinen 110 eingeschoben werden können und somit als Führungsschienen für die Montage dienen. In Figur 4 ist beispielhaft eine Isolationsschicht 33 zur thermischen und/oder elektrischen und/oder elektro-magnetischen Isolation zweier benachbarter Elektronikmodule 1 gezeigt. Dabei ist in dieser Ausführungsform die Isolationsschicht 33 geschlossen dargestellt, kann jedoch, wie für einen Fachmann leicht nachvollziehbar auch eine oder mehrere Öffnungen zum Durchführen von Elektronikbauteilen, Befestigungsmitteln, Kühlkanälen, etc. aufweisen. Die in Figur 4 beispielhaft dargestellte Isolationsschicht 33 zeigt zudem Steck- und/oder Klemm- Verbindungsmittel 35 auf jeder Seite, um die elektrische Verbindung sowie die Kommunikationsverbindung zwischen zwei benachbarten Elektronikmodulen 1 zu ermöglichen. In einer weiteren Ausführung kann die Isolationsschicht 33 auch eine metallische Platte 80 sein, um Wärme der Elektronikbauteile 130 im Inneren des Gehäuses 2 an die Gehäusewandung 4 und die Kühlvorrichtung 30 bzw. 40 weiterzuleiten.

Der in Figur 4 vormontierte Zustand ist in einer Schnittdarstellung in Figur 5 im montierten Zustand dargestellt, wobei erkennbar ist, dass die beiden zweiten Platinen 120 an ihrer Berührungsstelle über eine Steckverbindung 38 miteinander verbunden sein können. Auch die ersten Platinen 110 sind jeweils über Steckverbindungen 38 mit einer der beiden zweiten Platinen 120 verbunden.

Aus Figur 5 ist weiterhin gut die jeweilige Anpassung der Dome 25 zu erkennen, die bedarfsgerecht in ihrer Länge gekürzt sind, so dass die einzelnen ersten Platinen 110 parallel zueinander im Gehäuse 2 des erfindungsgemäßen Elektronikmoduls aufgenommen werden können. Auch in diesem Ausführungsbeispiel können die Dome 25 Schlitze 26 aufweisen, analog zu den in Figur 2 gezeigten geschlitzten Domen 25. An den beiden Stirnseiten 7 werden über die beiden zweiten Platinen 120 Steck- und/oder Klemm-Verbindungsmittel 35 an den jeweiligen Stirnseiten 7 des Elektronikmoduls 1 für die kabellose Anbindung weiterer Elektronikmodule 1 bereitgestellt. Im Weiteren entspricht das Elektronikmodul 1 im Wesentlichen dem Elektronikmodul 1, welches bereits in den Figuren 1 bis 3 dargestellt ist.

In der Figur 6 ist eine Einzelheit für eine beispielhafte erfindungsgemäße Befestigungsmöglichkeit von Elektronikbauteilen 130 gezeigt, die eine hohe Kühlleistung erfordern, da solche Elektronikbauteile im Betrieb unter Umständen sehr heiß werden können. Hier, im diesem beispielhaften Fall, handelt es sich etwa um MOSFETs, die so mit ihren Beinchen 135 an der ersten Platine 110 befestigt sind, dass ihre Gehäuse zwischen den Domen 25 zu liegen kommen. Damit über die Gehäuse der Elektronikbauteile 130 eine gute Wärmeleitung zur Gehäusewandung 4 des Elektronikmoduls ermöglicht werden kann, sind Klammern 60 vorgesehen, die an den Domen 25 beispielsweise anschraubbar sind, und deren elastische Kräfte derart wirken, dass die Gehäuse der Elektronikbauteile 130 (MOSFETs) an die Innenseite 5 der Gehäusewandung 4 gedrückt werden. Auch hier erkennt der Fachmann, dass eine Ausführung der Dome 25 mit Schlitzen 26 ebenfalls möglich ist, wobei die Schlitze 26 dann als Aufnahmenuten für in Längsrichtung 3 angeordnete Platinen 110, 120 dienen können.

Das in Figur 6 für eine Mehrzahl von Elektronikbauteilen 130 - MOSFETs oder andere Halbleiterleistungselektronikbauteile - dargestellte Montagebeispiel ist so ausgestaltet, dass die Klammern 60 zu einer Klemmleiste 62 zusammengefasst sind, die an die jeweiligen Dome 25 - welche wiederum in ihrer Höhe entsprechend angepasst sind - angeschraubt werden kann. An der Außenseite 6 der Gehäusewandung 4, die der Innenwandung 5 gegenüber liegt, an welche die Elektronikbauteile 130 angedrückt werden, sind zur besseren Wärmeabfuhr Kühlrippen 30 und beispielsweise ebenfalls Flüssigkeitskanäle 40, die in den Kühlrippen 30 integriert sein können, angeordnet. Durchgangslöcher 15, die in diesem Bereich ebenfalls in Längsrichtung 3 des Gehäuses ausgebildet sind, können auch hier für die Weiterleitung von Kühlflüssigkeit verwendet werden.

Für eine fluiddichte Abdichtung zweier benachbarter Elektronikmodule 1 zueinander ist beispielsweise eine Dichtungskontur 20 in die Stirnseite 7 des Gehäuses 2 eingearbeitet, in die beispielsweise eine Ringdichtung eingelegt werden kann. Dabei kann es bevorzugt sein, die Flüssigkeitskanäle 40 bzw. 15 ebenfalls mit Dichtringen zu versehen oder dort Verbindungsnippel 43 anzuordnen, die eine Abdichtung zwischen den einzelnen Flüssigkeitskanälen 40 zweier benachbarter Elektronikmodule 1 bzw. deren Gehäuse 2 ermöglicht.

Mit Bezugsziffer 18 ist in Figur 6 beispielhaft auch für die weiteren Dome 25 eine Bohrung gezeigt, die beispielsweise für die Aufnahme selbstschneidender Schrauben vorgesehen ist. Allerdings kann in diese Bohrung 18 ebenfalls ein Gewinde eingebracht werden, so dass beispielsweise Schrauben mit einem metrischen Gewinde verwendet werden können. Selbst wenn das Gehäuse 2 in der Figur 6 nur ausschnittsweise dargestellt ist, so entspricht es im Wesentlichen dem Gehäuse 2, welches in Figur 1 dargestellt ist.

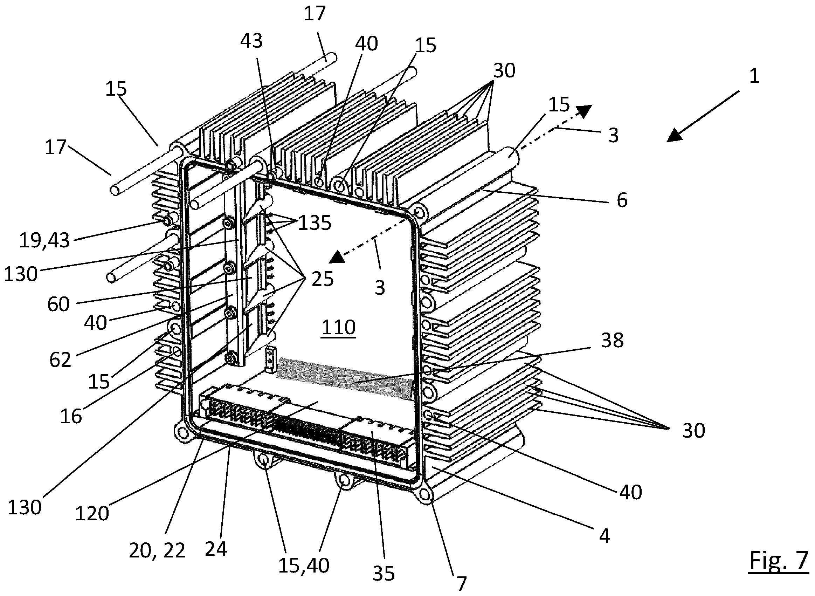

Figur 7 zeigt ein mit Elektronikbauteilen 100, insbesondere mit nur einer ersten Platine 110 und nur einer zweiten Platine 120 sowie mehreren Elektronikbauteilen 130 bestücktes Gehäuse 2, das ein erfindungsgemäßes Elektronikmodul 1 darstellt. Auf der sichtbaren Stirnseite 7 des Gehäuses 2 ist ein Dichtring 24 eingelegt und in einigen Durchgangslöchern 15 sind beispielhaft Gewindestangen 17 eingesetzt, auf die von beiden Seiten weitere erfindungsgemäße Elektronikmodule 1 aufgeschoben und mit dem in Figur 7 dargestellten Elektronikmodul 1 verbunden werden können. Dabei ist ersichtlich, dass der Anzahl in Linie/Reihe angeordneter, erfindungsgemäßer Elektronikmodule 1 keine Grenzen gesetzt sind, da die Gewindestangen 17 im Prinzip endlos ausgestaltet werden können. Neben den Gewindestangen 17 sind beispielsweise Passstifte 19 angeordnet, die zu einer Positionierung bzw. Zentrierung bei der Verbindung zweier Elektronikmodule 1 verwendet werden können. Leicht nachvollziehbar sind solche Passstifte 19 entsprechend gegebenenfalls auch auf der jeweils gegenüberliegenden Seite der Gehäusewandung 4 anzuordnen, um eine leichte Positionierung und Zentrierung der beiden benachbarten Elektronikmodule 1 zu erreichen. In einer bevorzugten Ausführungsform sind diese Passstifte 19 hohlgebohrt und können dann zusätzlich zu Verbindungsnippeln 43 zum Verbinden von Flüssigkeitskanälen 40 verwendet werden, wobei über geeignete Passungen - gegebenenfalls Presspassungen - auch eine Fluiddichtigkeit zum Gehäuse 2 hergestellt werden kann.

In einer anderen Ausführungsform kann über die hohlgebohrten Passstifte 19 bzw. die Verbindungsnippel 43 eine Flachdichtung bzw. Ringdichtung aufgeschoben werden, welche dann für die fluiddichte Verbindung der Flüssigkeitskanäle 40 herangezogen werden kann. Weitere in Figur 7 gezeigte Bauteile und Bauelemente sowie Komponenten des erfindungsgemäßen Elektronikmoduls 1 sind mit Bezugszeichen versehen, die zur Vermeidung von Wiederholungen bereits in den zuvor beschriebenen Figuren erläutert wurden. So ist durchaus vorstellbar, dass das in Figur 7 gezeigte Elektronikmodul 1 weitere nicht sichtbare erste Platinen 110 aufweist, die durch die im Vordergrund dargestellte erste Platine 110 verdeckt werden. Ein Gleiches gilt für die auf der anderen Stirnseite 7 angeordneten Steck- und/oder Klemm-Verbindungsmittel 35 auf einer (weiteren) zweiten Platine 120, welche auch dieselbe zweite Platine 120 sein kann, die in Figur 7 sichtbar ist. Jedoch können dies - vgl. Figuren 4 und 5 - auch zwei einzelne zweite Platinen 120 sein, die an ihrer jeweiligen Verbindungsstelle über Steckverbindungen 38 verbunden sein können.

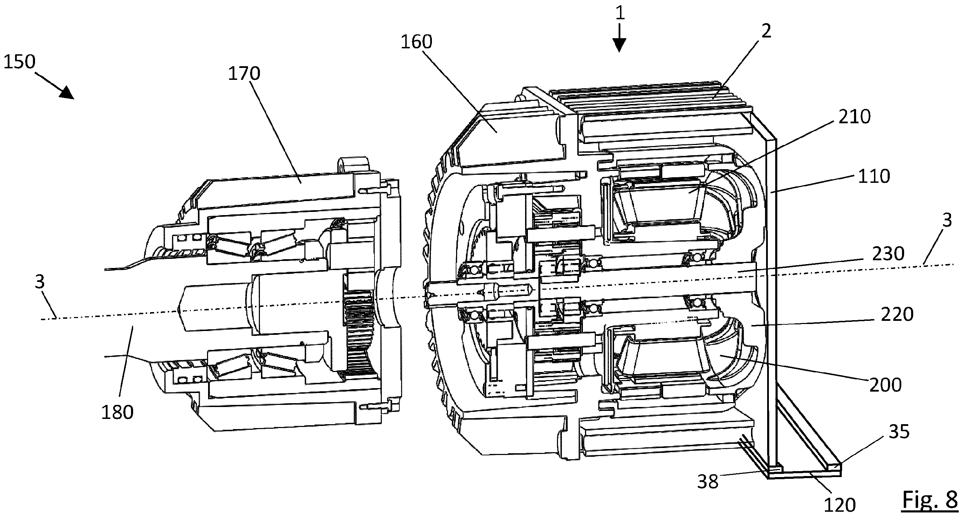

Mit Figur 8 ist ein spezieller Anwendungsfall für ein erfindungsgemäßes Elektronikmodul 1 gezeigt. Im Gehäuse 2 ist ein elektrischer Generator 200, mit einem Rotor 210 und einem Stator 220 angeordnet, dessen Antriebswelle in Längsrichtung 3 des Elektronikmoduls 1 ausgerichtet ist. Dabei kann das erfindungsgemäße Elektronikmodul 1 an weitere Bauelemente 160, 170 eines mechanischen Antriebsstranges 150 für den Antrieb der Generatorwelle 230 angeflanscht werden. Das in Figur 8 dargestellte Beispiel eines Antriebsstrangs 150 zeigt ein an das erfindungsgemäße Elektronikmodul-Gehäuse 2 angeflanschtes Gleichlaufgetriebe 160 mit einem davor angeordneten Planetengetriebe 170, das von einer Antriebswelle 180 in Drehung versetzt werden kann. Ein solcher Antriebsstrang 150 für den Drehantrieb des Generators 200 kann beispielsweise in einem Wellenkraftwerk Anwendung finden, bei dem die Antriebswelle 180 in beiden Drehrichtungen angetrieben werden kann. Über das Gleichlaufgetriebe 160 wird die Drehrichtung vereinheitlicht, so dass der Generator 200 immer in derselben Richtung betrieben wird und seine Leistung beispielsweise über eine im Elektronikmodul 1 angeordnete erste Platine 110 und einer daran angesteckten zweiten Platine 120 an weitere Elektronikmodule 1 weitergeben kann.

Ein ähnlicher Antriebsstrang an den erfindungsgemäße Elektronikmodule 1 angeflanscht werden können, ist beispielsweise für Windkraftwerke denkbar, wobei hier kein Gleichlaufgetriebe erforderlich ist, da Windkrafträder nur in einer Drehrichtung betrieben werden. Allerdings treten hier große Drehzahlschwankungen auf, so dass eine Vergleichmäßigung der erzeugten Energie über die in den angeflanschten Elektronikmodulen 1 aufgenommenen Elektronikbauteilen 100 erreicht werden kann.

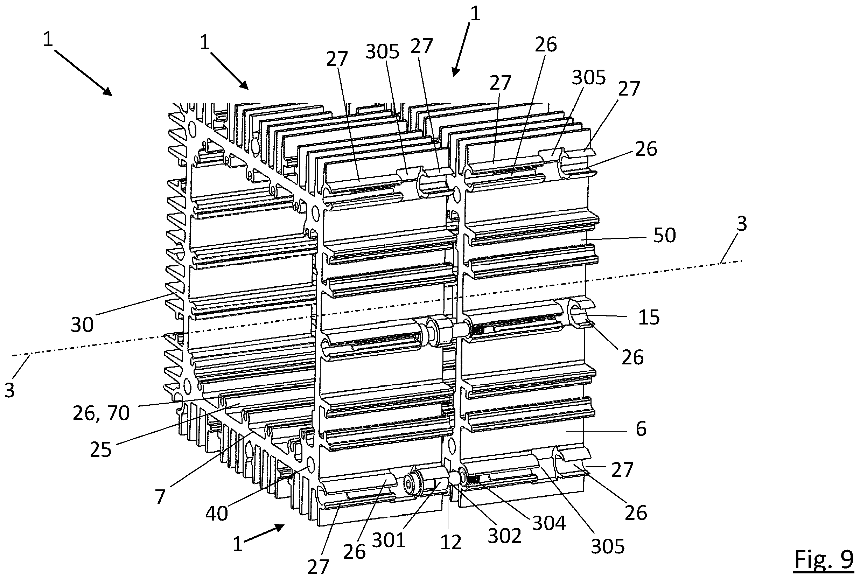

Figur 9 zeigt eine beispielhafte Ausführung eines Elektronikmoduls, bei dem die Zusammenbau- und/oder Demontagereihenfolge von mindestens zwei Elektronikmodulen 1, die hintereinander in Längsrichtung 3 angeordnet werden, vorgeben sein kann. In Anbindungsdome 27 an der Gehäuseaußenseite 6, in denen sich die Durchgangslöcher 15 befinden, ist ein Schlitz 26 eingebracht. Ein Teil der sich in Längsrichtung 3 über die Gehäuseaußenseite 6 erstreckenden Anbindungsdome 27 an der Gehäuseaußenseite 6 ist abgetragen. An der Stirnseite 7 des Gehäuses des ersten Elektronikmoduls 1, an welche das nächste Elektronikmodul 1 angebracht wird, sind Gewindeeinsätze 304 in die Anbindungsdome 27 eingesetzt.

Auf der Stirnseite 7 des anzuschließenden Elektronikmoduls 1 sind Schrauben 302 über die Schlitze 26 in Freimachungen 305 quer zur Längsrichtung 3 eingesetzt, wobei die Köpfe der Schrauben 302 in dem freigemachten Teil der Anbindungsdome 27 Platz finden. Die Schrauben 302 werden gegen ein Herausfallen durch Führungshülsen 301 gesichert, die in Längsrichtung 3 in die Durchgangslöcher 15 eingesetzt werden.

Die Schrauben werden mit einem Schraubenzieher, dessen Klinge durch das Durchgangsloch des Anbindungsdomes 27 gesteckt wird, angezogen. Somit ist es nur möglich, die Schrauben 302 des jeweils oberen Moduls anzuziehen, die nicht durch ein darüber liegendes Modul verdeckt sind. Bei der Demontage einer Elektronikmodulbaugruppe 300 können nur die Schrauben 302 des oberen Moduls 1 gelöst werden, da die Schrauben 302 eines anderen dahinter (darunter) angeordneten Elektronikmoduls 1 verdeckt sind.

Über die Steckverbindungen 35 zwischen den zweiten Platinen 120 werden in einer Elektronikmodulbaugruppe 300 Leistungs- und/oder Kommunikationssignale zwischen den Elektronikmodulen 1 übertragen. Diese können für den Anwender ein Sicherheitsrisiko darstellen, wenn durch Berühren eines Steckers über den Körper ein Stromkreis geschlossen wird oder es zur Ausbildung eines Lichtbogens kommt. Wird aber der Stromkreis schon beim Öffnen der Elektronikmodulbaugruppe 300 an der richtigen Stelle, die beispielsweise durch einen Sicherheitsmechanismus vorgegeben ist, unterbrochen, besteht für den menschlichen Körper keine Gefahr mehr. Ein solcher Sicherheitsmechanismus 12 kann beispielsweise angewendet werden, wenn sichergestellt werden soll, dass beim Trennen von mindestens zwei Elektronikmodulen 1 die Stecker 35 und/oder 38 auf den zweiten Platinen 120 der Elektronikmodule 1, deren Schraubenköpfe zugänglich sind, zuerst getrennt werden, wodurch die Trennung der Elektronikmodule 1 in einer vorbestimmten Reihenfolge gewährleistet werden kann.

In einer weiteren Ausführungsform sind auf den zweiten Platinen 120 zum Weiterleiten von Leistungs- und/oder Kommunikationssignalen im Inneren der Elektronikmodule 1 Stecker 38 angeordnet, die nur dann eine leitende Verbindung zwischen Elektronikmodulen 1 herstellen, wenn die Module vollständig zusammengeschraubt sind. Abhängig von den im Modul enthaltenen Elektronikkomponenten 100 kann ein Monteur der Gefahr eines Stromschlags ausgesetzt sein, wenn beispielsweise vormontierte Elektronikmodulbaugruppen 300 an einer mittleren Position in einen Elektronikmodulstrang zusammengefasst werden. Beim Aufbau einer Elektronikmodulbaugruppe 300, bei der alle Schrauben an der Gehäuseaußenseite zugänglich sind oder die Elektronikbaugruppe 300 mittels Gewindestangen 17 zumindest teilweise zusammen gehalten wird, lässt sich diese Gefahr nicht vollständig ausschließen. Durch die Anordnung der Schrauben beispielsweise auf unterschiedlicher Höhe in Längsrichtung oder durch Verdeckung von Schrauben, die in zuerst zu lösende Elektronikmodule 1 eingreifen, kann diese Gefahr jedoch umgangen werden.

In dieser beispielhaften Ausführung des Sicherheitsmechanismus gemäß Figur 9 sind die abgetragen Teile der Dome 25 nicht alle auf der gleichen Höhe in Längsrichtung angeordnet. Dadurch sind die Schraubenköpfe der Schrauben 302, die in den abgetragenen Teilen der Anbindungsdome 27 angeordnet sind, auf unterschiedlichen Höhen angeordnet. Bei einem Zusammensetzten der Module ist erforderlich, zunächst die Schrauben 302, deren Köpfe 320 am nächsten an der Stirnseite des Elektronikmoduls 1 angeordnet sind, anzuziehen bevor die Schrauben 302 mit Köpfen 320, die weiter von der Stirnseite entfernt sind, angezogen werden können. Durch eine derartige Vorrichtung kann ein Monteur dazu gezwungen werden, Elektronikmodule 1 immer erst vollständig zu verschrauben, bevor ein neues Elektronikmodul 1 aufgesetzt werden kann. Sind nämlich die Schrauben 302 des Elektronikmoduls 1 nicht vollständig angezogen, können die ersten Schrauben 302 des an das erste Elektronikmodul 1 anzubringenden zweiten Elektronikmoduls 1 beispielsweise nicht in den Gewindeeinsatz eingreifen.

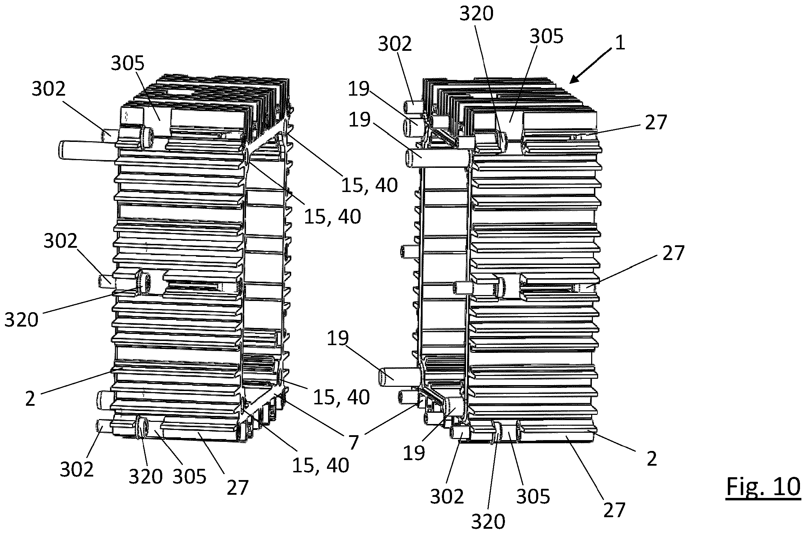

Figur 10 zeigt eine beispielhafte Ausführung eines Elektronikmoduls 1 mit einer Kombinationskodierung, welche die Kombinationsmöglichkeiten bei der Aneinanderreihung von mehreren Elektronikmodulen 1 in Längsrichtung 3 vorgibt. Die Gehäuse 2 der Elektronikmodule 1 weisen Durchgangslöcher 15 auf, die in Längsrichtung 3 von einer ersten Stirnseite 7 des Gehäuses 2 zu einer zweiten Stirnseite 7 des Gehäuses 2 reichen. In einer beispielhaften Ausführung sind die Durchgangslöcher 15 von der ersten Stirnseite 7 her so ausgebildet, beispielsweise durch eine Nachbearbeitung, dass Passstifte 19 in die Durchgangslöcher eingesetzt werden, wobei die Passstifte 19 unterschiedliche Längen und/oder Durchmesser aufweisen können. Von der zweiten Stirnseite 7 her sind die Durchgangslöcher 15 der Gehäuse 2 so ausgebildet, beispielsweise durch Aufbohren, dass nur die Passstifte 19, die eine gewisse Länge und/oder einen gewissen Durchmesser nicht überschreiten, in den Durchgangslöchern 15 der Stirnseite 7 des zweiten Elektronikmoduls 1 aufgenommen werden können. Zwei Elektronikmodule 1 können also nur dann miteinander kombiniert werden, wenn die Länge und/oder der Durchmesser der Passstifte 19 mit den Tiefen und/oder den Durchmessern der Nachbearbeitung der Durchgangslöcher 15 des zweiten Elektronikmoduls 1 komplementär sind. In einem modularen System von Elektronikmodulen 1 kann durch dieses "Lego-ähnliche" Prinzip ein Kodierungssystem aufgebaut werden, bei dem nur bestimmte Gehäuse 2 miteinander kombiniert werden können, was dem Benutzer den korrekten Zusammenbau einer aus mehreren Elektronikmodulen 1 bestehenden Baugruppe erleichtert.

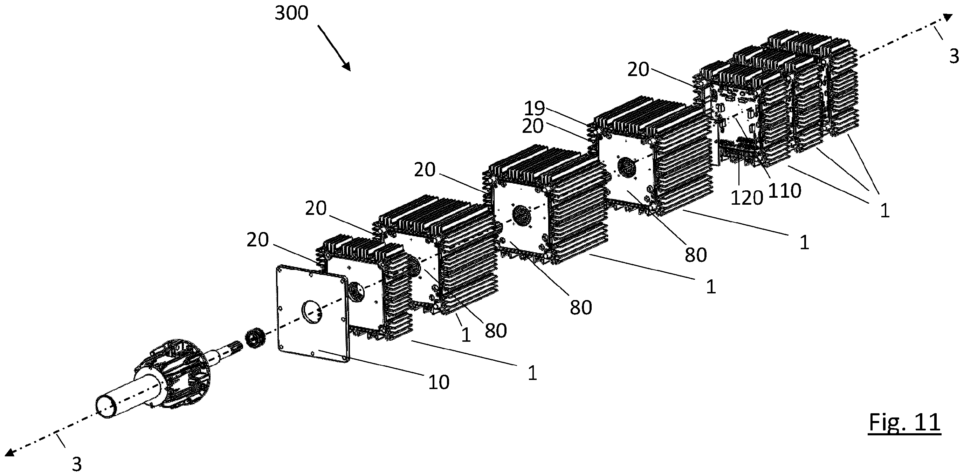

Figur 11 zeigt eine Explosionszeichnung einer beispielhaften Aneinanderreihung in Längsrichtung von mehreren erfindungsgemäßen Elektronikmodulen 1 zu einer Elektronikmodulbaugruppe 300, wie sie beispielsweise zur Wandlung regenerativer Energie in Wellenkraftwerken verwendet werden könnte. Von links nach rechts sind ein Elektronikmodul 1, das ein mechanisches Lagerpaket enthält, ein Abschlussbauteil 10 in Form einer Platte, ein Elektronikmodul 1, das eine mechanische Bremse enthält, drei Elektromaschinen 200 enthaltende Elektronikmodule 1, und drei Elektronikmodule 1, welche leistungselektronische Komponenten und Elektronikbauteile 100, wie Spannungswandler, MOSFESTs, Widerstände, Mikrokontroller, etc. enthalten, aneinandergereiht. Die Elektronikmodule 1 sind in der beispielhaften Ausführung beispielsweise über Passstifte in einer Ebene orthogonal zur Längsrichtung 3 zueinander positioniert. Die Wellen der Elektronmaschinen 200 sind mit Verlängerungswellen, welche die Wellen der Elektromaschinen miteinander mechanisch verbinden, drehfest durch Keilwellenverbindungen verbunden.

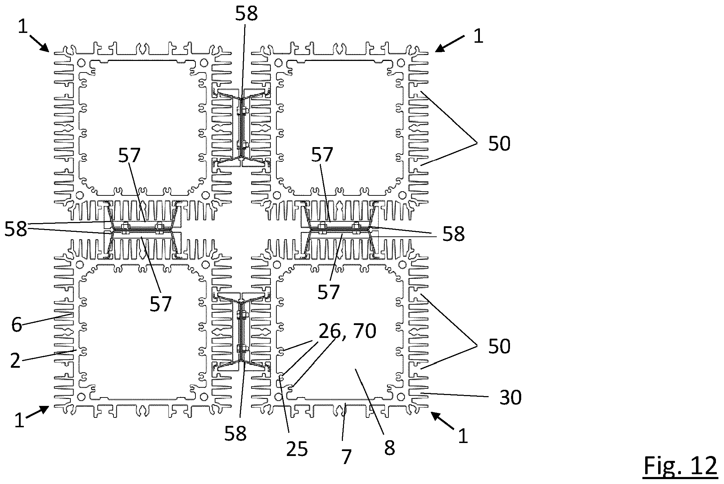

Figur 12 zeigt eine beispielhafte seitliche Anordnung von mehreren erfindungsgemäßen Elektronikmodulen 1 quer zur Längsrichtung 3. Die Gehäuse 2 der Elektronikmodule 1 weisen an den Gehäuseaußenseiten 6 Führungsschienen 50 auf, die einen Hinterschnitt aufweisen, der quer zur Längsrichtung 3 angeordnet ist. In diesen können zur Form der Führungsschienen 50 komplementär ausgebildete Verbindungselemente 58 eingesetzt werden. Die Verbindungselemente 58 weisen einen bevorzugt symmetrischen Aufbau auf und ähneln in der gezeigten beispielhaften Ausführungsform der Form eines Doppel-T. Es ist vom Erfindungsgedanken umfasst, die Verbindungselemente 58 entweder ein- oder mehrteilig auszuführen, beispielsweise zur Erleichterung von Fertigung und/oder Montage der Verbindungselemente 58. Dem Fachmann ist hierbei bekannt, dass viele, sowohl zueinander parallele als auch nicht parallele Teilungsebenen existieren, an welchen die bevorzugt symmetrischen Verbindungselemente 58 unterteilt werden können. Ebenfalls liegt es im Bereich des fachmännischen Könnens, zum Zusammenfügen von geteilten Verbindungselementen 58 ein geeignetes Verfahren auszuwählen.

Des Weiteren ist es vom Erfindungsgedanken umfasst, eine Verspannvorrichtung 59 an den Verbindungselementen 58 anzuordnen, mittels derer die Verbindungselemente 58 gegen die Führungsschiene 50 verspannt werden können. In Figur 12 ist zu diesem Zweck ein Drehmechanismus 57 dargestellt, der eine durch seine Drehposition beispielsweise einstellbare Kraft auf die Verbindungselemente 58 ausübt und diese so gegen die Führungsschiene 50 drückt. Selbstredend sind auch andere Verspannvorrichtungen bzw. -mechanismen vom Erfindungsgedanken umfasst, welche im Bereich des fachmännischen Könnens liegen.

Insgesamt lässt das erfindungsgemäße Elektronikmodul-System eine flexible Zusammenstellung verschiedenster Elektronikbauteile zu, wobei die Gehäuse, in denen die Elektronikbauteile und Elektromaschinen aufgenommen sind, standardisiert, teilstandardisiert bzw. normiert werden können, so dass in einer Art Baukastensystem für jeden Anwendungsfall, sei es für regenerative Energien als auch für "herkömmliche" Energien, je nach Bedarf, die erforderlichen Elektronikkomponenten zusammensteckbar sind. Die so zusammengestellten Elektronikbaugruppen können auch durch mechanische Baugruppen, wie beispielsweise Bremsen, Getriebe oder Lagerpakete, modular erweitert werden. Mit den erfindungsgemäßen Steckverbindungen wird zudem viel Handarbeit bei der Verbindung der einzelnen Elektronikmodule vermieden, da Abschirmungen, wie sie bei elektrisch durchflossenen Leitern notwendig sind, insbesondere solche durch die hohe Ströme fließen, in die Platinen integrierbar sind. Solche Abschirmungen können herkömmlicherweise bereits bei Aufbau der jeweiligen Platinen berücksichtigt werden und müssen nicht, ähnlich wie bei Antennenkabeln, nachträglich beim elektrischen Verbinden für jedes Kabel miteinander verbunden werden.

Somit stellt das erfindungsgemäße Elektronikmodul-System ein einfaches, kostengünstiges als auch robustes System für die Zusammenstellung notwendiger Leistungselektronik bzw. Kommunikationsplattformen dar, die modulhaft im Baukastensystem zusammengestellt werden können.

**Bezugszeichenliste**

| | | | |
|---|---|---|---|
| 1 | Elektronikgehäusemodul | | |
| 2 | Gehäuse | 50 | Führungsschiene |
| 3 | Längsrichtung | 55 | Führungsstein |
| 4 | Gehäusewandung | 57 | Drehmechanismus |
| 5 | Gehäuseinnenseite | 58 | Verbindungselement |
| 6 | Gehäuseaußenseite | 59 | Verspannvorrichtung |
| 7 | Stirnseite | 60 | Klammer |
| 8 | Gehäuseöffnung | 62 | Klemmleiste |
| | | 70 | Aufnahmenut |
| 10 | Abschlussbauteile | 80 | Metallische Platte |
| 12 | Sicherheitsvorrichtung | 100 | Elektronikbauteil |
| 13 | Zugfeder | 110 | Erste Platine |
| 14 | Anschlag | 120 | Zweite Platine |
| 15 | Durchgangslöcher | 130 | MOSFET |
| 16 | Bohrungen | | |
| 17 | Gewindestangen | 135 | Beinchen |
| 18 | Bohrung | | |
| 19 | Passstifte | 150 | Antriebsstrang |
| 20 | Dichtkontur | 160 | Gleichlaufgetriebe |
| 22 | Dichtfläche | 170 | Planetengetriebe |
| 24 | Dichtung/Dichtring | 180 | Antriebswelle |
| 25 | Dome | | |
| 26 | Schlitz | 200 | Generator |
| 27 | Anbindungsdome | 210 | Rotor/Rotorbaugruppe |
| 28 | Ausnehmungen | 220 | Stator/Statorbaugruppe |
| 30 | Kühlrippen | 230 | Generatorwelle/Rotorwelle |
| | | | |
| 33 | Isolationsschicht | 300 | Elektronikmodulbaugruppe |
| 35 | Steck- und/oder Klemm-Verbindungsmittel | 301 | Führungshülse |
| | | 302 | Schrauben |
| 38 | Steckverbindung | 304 | Gewindeeinsätze |
| 39 | Buchse | 305 | Freimachung |
| 40 | Flüssigkeitskanäle | | |
| 43 | Verbindungsnippel | 320 | Schraubenkopf |

## Patentansprüche

1. Elektronikmodul (1) für die Aufnahme von Elektronikbauteilen (100), mit einem Gehäuse (2), das in einer Längsrichtung (3) durch zwei jeweils eine Öffnung (8) aufweisende Stirnseiten (7) begrenzt ist, sodass das Gehäuse (2) über die Öffnungen (8) mit zumindest einer, mit Elektronikbauteilen (100) versehenen, ersten Platine (110) und mit zumindest einer, mit Steck- und/oder Klemm-Verbindungsmittel (35) versehenen, zweiten Platine (120) bestückbar ist, wobei auf der zumindest einen zweiten Platine (120) weitere Steck- und/oder Klemm-Verbindungsmittel (35, 38) derart angeordnet sind, dass Steck- und/oder Klemm-Verbindungsmittel (35, 38) eines weiteren Elektronikmoduls (1) zum Weiterleiten von elektrischer Leistung und Kommunikationssignalen mit der zumindest einen zweiten Platine (120) mittels Steck- und/oder Klemm-Verbindungsmittel (35, 38) kabellos verbunden werden können,
**dadurch gekennzeichnet, dass** das Gehäuse (2) an einer Innenseite (5) einer Gehäusewandung (4) zumindest einen in Längsrichtung (3) ausgebildeten Dom (25) aufweist, an dem die zumindest eine erste Platine (110) im Wesentlichen quer zur Längsrichtung (3) befestigt werden kann, und das Gehäuse (2) weiter an zwei einander gegenüberliegenden Innenseiten (5) und/oder an zwei gegenüberliegenden Domen (25) jeweils eine Aufnahmenut (70) zum Einschieben zumindest einer zweiten Platine (120) in Längsrichtung (3) aufweist, wobei die zumindest eine erste Platine (110) und die zumindest eine zweite Platine (120) innerhalb des Gehäuses (2) zum Weiterleiten von elektrischer Leistung und Kommunikationssignalen kabellos mittels Steck- und/oder Klemm-Verbindungsmittel (35, 38) elektrisch miteinander verbunden sind.

2. Elektronikmodul (1) nach Anspruch 1, das eine Vielzahl an sich in Längsrichtung (3) erstreckenden Aufnahmenuten (70) und/oder Schlitzen (26) aufweist, die an paarweise gegenüberliegenden Gehäuseinnenseiten (5) und/oder Domen (25) angeordnet sind, , wobei mehrere erste Platinen (110) und/oder zweite Platinen (120) in den sich in Längsrichtung (3) erstreckenden Aufnahmenuten (70) angeordnet sind und die in Längsrichtung (3) angeordneten Platinen (110, 120) mittels Steck- und/oder Klemmverbindungsmittel (35, 38) kabellos mit quer zur Längsrichtung (3) angeordneten Platinen (110, 120) verbunden werden können.

3. Elektronikmodul (1) nach Anspruch 1 oder 2, bei dem das Gehäuse (2) durch Urformen aus einem Metall im Strangpress-, Strangguss-, oder (Druck-)Gussverfahren, bevorzugt aus Aluminium oder einer Aluminiumlegierung, oder aus einem Kunststoff im Spritzguss- oder Extrudierverfahren hergestellt ist.

4. Elektronikmodul (1) nach einem der vorherigen Ansprüche, bei dem an der Gehäusewandung (4) Kühlrippen (30) angeordnet sind, die sich im Wesentlichen in Ebenen parallel zur Längsrichtung erstrecken, und/oder Flüssigkeitskanäle (40) in der Gehäusewandung (4) in Längsrichtung (3) eingebracht sind, die ein Weiterleiten von Kühlflüssigkeit zwischen den einzelnen Gehäusen (2) ermöglichen.

5. Elektronikmodul (1) nach einem der vorherigen Ansprüche, bei dem an zumindest einem Dom (25) zumindest eine Klammer (60) derart befestigt werden kann, bevorzugt verschraubt in Längsrichtung (3), dass die Klemmkraft im Wesentlichen quer oder schräg zur Längsrichtung (3) wirkt.

6. Elektronikmodul (1) nach Anspruch 5, bei dem mittels der Klammer (60) und/oder einer mehrere Klammern (60) aufweisenden Klemmleiste (62) ein oder mehrere im Betrieb zu kühlende Elektronikbauteile (130) flächig so gegen die Innenseite (5) der Gehäusewandung (4) gedrückt werden können, dass eine direkte Wärmeleitung vom Gehäuse der Elektronikbauteile (130) auf die Gehäusewandung (4) und/oder an die Klammer (60) und/oder Klemmleiste (62) ermöglicht wird.

7. Elektronikmodul (1) nach einem der vorherigen Ansprüche, bei dem das Gehäuse (2) eine in Umfangsrichtung geschlossene, rahmenartige, profiliert ausgebildete Gehäusewandung (4) aufweist, die in Längsrichtung (3) durch die Stirnseiten (7) derart begrenzt wird, dass in Längsrichtung (3) mehrere Gehäuse (2) im Wesentlichen deckungsgleich aneinandergereiht miteinander verbunden werden können, bevorzugt über in der Gehäusewandung (4) ausgebildete Durchgangslöcher (15), wobei auf den Stirnseiten (7) eine umlaufende Dichtkontur (20) oder eine Dichtfläche (22) ausgebildet sein kann, zum fluiddichten Verbinden benachbarter Gehäuse (2) in Längsrichtung mittels einer O-Ring-, Flach-, Schaum-, oder Klebedichtung (24).

8. Elektronikmodul (1) nach einem der Ansprüche 4 oder 7, bei dem die Durchgangslöcher (15) und/oder Flüssigkeitskanäle (40) und/oder Kühlrippen (30) an der Innenseite (5) und/oder der Außenseite (6) der Gehäusewandung (4) und/oder an den Domen (25) angeordnet sind.

9. Elektronikmodul (1) nach einem der Ansprüche 7 oder 8, bei dem die Durchgangslöcher (15) Gewinde aufweisen, mittels derer beispielsweise Abschlussbauteile (10), die das Gehäuse (2) in Längsrichtung (3) verschließen, befestigt werden können, wobei die Verbindung zwischen Gehäuse (2) und den Abschlussbauteilen (10) mittels einer Dichtung (4) fluiddicht ausgestaltet sein kann und die Abschlussbauteile (10) Steck- und/oder Klemm- Verbindungsmittel (35) zum kabellosen Verbinden und Weiterleiten von elektrischer Leistung und Kommunikationssignalen zu und von den ersten und zweiten Platinen (110, 120), die im Gehäuse (2) angeordnet sind, aufweisen können.

10. Elektronikmodul (1) nach einem der Ansprüche 7 bis 9, bei dem die Gehäusewandung (4) weiter in Längsrichtung (3) ausgebildete, an der Außenseite (6) angeordnete Führungsschienen (50) und/oder Führungssteine (53) aufweist, um eine seitliche Verbindungsmöglichkeit der Gehäuse (2) untereinander, die Anbindung der Gehäuse (2) an eine Montageschiene, die Aufnahme der Gehäuse (2) in einem Schaltschrank und/oder die Befestigung der Gehäuse (2) an weiteren Vorrichtungen, insbesondere an genormten Befestigungseinrichtungen, bereitzustellen.

11. Elektronikmodul (1) nach Anspruch 10, bei dem die an der Außenseite (6) angeordneten Führungsschienen (50) einen Hinterschnitt, der quer zur Längsrichtung angeordnet ist, für das Einsetzen von in Teilbereichen komplementär ausgebildeten Verbindungselementen (58) aufweisen, mit denen zwei Gehäuse (2) miteinander oder das Gehäuse (2) an Montageschienen oder Befestigungseinrichtungen quer zur Längsrichtung fixierbar ist, wobei die Verbindungselemente (58) bevorzugt einen symmetrischen Aufbau in Form eines Doppel-T, einer doppelten Schwalbenschanzführung oder eines Knochen aufweisen und mehrteilig ausgeführt sein können.

12. Elektronikmodul (1) nach einem der vorherigen Ansprüche, dessen Gehäuse (2) form- und/oder kraft- und/oder stoffschlüssig mit dem Gehäuse mindestens eines anderen Elektronikmoduls (1) verbunden werden kann, wobei ein Sicherheitsmechanismus (12) vorgesehen ist, der die Reihenfolge und/oder die Kombinationsmöglichkeiten vorgibt, in der die Elektronikmodule in Längsrichtung (3) miteinander verbindbar und wieder voneinander trennbar sind.

13. Elektronikmodul nach einem der vorherigen Ansprüche, bei dem eine durch eine elastische Rückstellkraft verschiebbare Sicherheitsvorrichtung die Kontaktierung zwischen nicht berührgeschützten Steck- und/oder Klemmverbindungsmitteln (35) und spannungsführenden Elektronikbauteilen (100) unterbricht oder spannungsführende, nicht berührgeschützte Steck- und/oder Klemmverbindungsmittel (35) abdeckt.

14. Elektronikmodul (1) nach einem der Ansprüche 4 bis 13, bei dem zwischen zwei in Längsrichtung benachbarten Gehäusen (2), bevorzugt mittels der Durchgangslöcher (15), eine thermische Isolationsplatte (33) angeordnet werden kann, wobei zwischen der thermischen Isolationsplatte (33) und der jeweiligen Stirnfläche (7) eines der beiden Gehäuse (2) eine Dichtung (24) angeordnet sein kann.

15. Elektronikmodul (1) nach einem der vorherigen Ansprüche, in welchem mehrere Dome (25) und/oder Kühlrippen (30) an den Innenseiten der Gehäusewandung (4) derart ausgebildet sind, dass zumindest eine metallische Platte (80) im Wesentlichen quer zur Längsrichtung (3) thermisch leitend daran angeordnet werden kann, sodass eine Wärmeableitung über die metallische Platte an das Gehäuse (2) möglich ist, wobei auf einer oder auf beiden Seiten der zumindest einen Platte (80) erste Platinen (110) und/oder Elektronikbauteile (100) elektrisch isoliert angeordnet werden können, sodass diese mit den zweiten Platinen (120) kabellos zum Weiterleiten von elektrischer Leistung und/oder Kommunikationssignalen verbunden werden können.

16. Elektronikmodul (1) nach Anspruch 15, in welchem zwischen zwei metallischen Platten (80) ein oder mehrere Akkumulatoren bzw. ein oder mehrere Akkumulatoren-Packs mit einer die Pole der Akkumulatoren elektrisch verbindenden ersten Platine (110) mittels der beiden metallischen Platten (80) im Gehäuse (2) in Längsrichtung (3) befestigbar sind und mittels eines Vergussmaterials, Schaummaterials oder einstellbaren Keilvorrichtungen an zumindest zwei benachbarten Seitenflächen die Akkumulatoren (140) bzw. die Akkumulatoren-Packs im Gehäuse (2) quer zur Längsrichtung (3) derart festgesetzt werden können, dass ein Aufquellen der Akkumulatoren bzw. der Akkumulatoren-Packs in Längsrichtung (3) und/oder quer zur Längsrichtung (3) im Wesentlichen verhindert wird und eine Wärmeableitung über die metallischen Platten (80) und die Keilvorrichtungen oder das Vergussmaterial oder das Schaummaterial an das Gehäuse (2) ermöglicht wird.

17. Elektronikmodul (1) nach Anspruch 16, bei dem Kräfte, die von den Keilvorrichtungen quer zur Längsrichtung (3) auf die Akkumulatoren bzw. Akkumulatoren-Packs ausgeübt werden, mittels Einstellschrauben, die sich an den metallischen Platten (80) abstützen, einstellbar sind.

18. Elektronikmodul (1) nach einem der Ansprüche 1 bis 17, bei dem im Gehäuse (2) eine Elektromaschine (200) aufgenommen ist, deren Rotationsachse in Längsrichtung (3) des Elektronikmoduls (1) ausgerichtet ist, wobei die Statorbaugruppe (220) gehäusefest ist und die Rotorbaugruppe (210) mittels einer Rotorwelle (230) in Rotationslagern (240) gelagert ist, die in quer zur Längsrichtung im Gehäuse (2) angeordneten metallischen Platten (80) eingebracht sind.

19. Elektronikmodulbaugruppe mit zumindest einem ersten eine Elektromaschine (200) aufweisenden Elektronikmodul (1) gemäß Anspruch 18 und zumindest einem zweiten zumindest eine erste Platine (110) und/oder zumindest eine zweite Platine (120) aufweisenden Elektronikmodul (1) gemäß einem der Ansprüche 1 bis 17, wobei zwischen den Elektronikmodulen (1) elektrische Leistungs- und/oder Kommunikationssignale mittels zweiter Platinen (120) übertragbar sind und zusätzlich zwischen den Elektronikmodulen (1), die Elektromaschinen (200) aufweisen, mechanische Leistung über drehfeste Verbindungen der Rotorwellen (230) der Elektromaschinen (200) übertragen werden kann.

20. Elektronikmodulbaugruppe nach Anspruch 19, wobei Leistungs- und/oder Kommunikationssignale zwischen den Rotorbaugruppen (210) und/oder den Statorbaugruppen (220) und den ersten Platinen (110) bzw. Elektronikbauteilen (100) mittels Kabel übertragen werden können.

## Claims

1. Electronic module (1) for accommodating electronic components (100), with a housing (2) which is bounded in a longitudinal direction (3) by two end faces (7), each comprising an opening (8), such that the housing (2) can be fitted via the openings (8) with at least one first circuit board (110) equipped with electronic components (100) and with at least one second circuit board (120) equipped with plug and/or clamp connectors (35), whereby on the at least one second circuit board (120) additional plug and/or clamp connectors (35, 38) are arranged in such a way that plug and/or clamp connectors (35, 38) of another electronic module (1) can be wirelessly connected to the at least one second circuit board (120) via plug and/or clamp connectors (38) for the transmission of electrical power and communication signals,
**characterized in that** the housing (2), on the inner side (5) of a housing wall (4), exhibits at least one dome (25) configured in a longitudinal direction (3) to which the at least one first circuit board (110) can be attached essentially transversely to the longitudinal direction (3), and the housing (2) further exhibits, on two opposite-facing inner sides (5) and/or two opposite-facing domes (25), a retaining groove (70) in each case for the insertion of at least one second circuit board (120) in the longitudinal direction (3), wherein the at least one first circuit board (110) and the at least one second circuit board (120) are wirelessly electrically connected to each other inside the housing (2) via plug and/or clamp connectors (35, 38) for the transmission of electrical power and communication signals.

2. Electronic module (1) according to Claim 1 which exhibits numerous retaining grooves (70) and/or slots (26) extending in an essentially longitudinal direction (3), which are arranged on pairwise opposite-facing housing inner sides (5) and/or domes (25), wherein several first circuit boards (110) and/or second circuit boards (120) are arranged in the retaining grooves (70) extending in the longitudinal direction (3) and the circuit boards (110, 120) arranged in the longitudinal direction (3) can be wirelessly connected via plug and/or clamp connectors (35, 38) to circuit boards (110/120) arranged transversely to the longitudinal direction (3).

3. Electronic module (1) according to Claim 1 or 2, in which the housing (2) is made by means of casting from a metal using the extrusion, continuous casting or (pressure) casting method, preferably from aluminium or an aluminium alloy, or from a plastic by means of injection moulding or extrusion.

4. Electronic module (1) according to one of the previous claims, in which cooling fins (30) are arranged on the housing wall (4) which extend essentially in planes parallel to the longitudinal direction, and/or fluid channels (40) are applied on the housing wall (4) in the longitudinal direction (3) which enable coolant to be passed on between the individual housings (2).

5. Electronic module (1) according to one of the previous claims, in which on at least one dome (25) at least one clip (60) can be attached in such a way, preferably screwed in the longitudinal direction (3), that the clamping force essentially acts transversely or obliquely to the longitudinal direction (3).

6. Electronic module (1) according to Claim 5, in which the clip (60) and/or a terminal strip (62) comprising several clips (60) can be used to press one or several electronic components (130) requiring cooling during operation flat against the inner side (5) of the housing wall (4) in such a way as to enable direct heat dissipation from the housing of the electronic components (130) to the housing wall (4) and/or to the clip (60) and/or terminal strip (62).

7. Electronic module (1) according to one of the previous claims, in which the housing (2) exhibits a housing wall (4) configured in a frame-like, profiled manner and closed in the circumferential direction, which is bounded in the longitudinal direction (3) by the end faces (7) in such a way that in the longitudinal direction (3) several housings (2) which are strung together essentially congruently can be connected to each other, preferably via through-holes (15) configured in the housing wall (4), wherein a circumferential sealing contour (20) or a sealing surface (22) can be configured on the end faces (7) for the fluid-tight connection of neighbouring housings (2) in the longitudinal direction by means of an O-ring seal, flat seal, foam seal or adhesive seal (24).

8. Electronic module (1) according to one of Claims 4 or 7, in which the through-holes (15) and/or liquid channels (40) and/or cooling fins (30) are arranged on the inner side (5) and/or the outer side (6) of the housing wall (4) and/or on the domes (25).

9. Electronic module (1) according to one of Claims 7 or 8, in which the through-holes (15) exhibit threads by means of which, for example, end components (10) which close the housing (2) in the longitudinal direction (3) can be attached, wherein the connection between the housing (2) and the end components (10) can be configured by means of a seal (4) to be fluid-tight and the end components (10) can exhibit plug and/or clamp connectors (35) for wireless connection and transmission of electrical power and communication signals to and from the first and second circuit boards (110, 120) arranged in the housing (2).

10. Electronic module (1) according to one of Claims 7 to 9, in which the housing wall (4) exhibits guide rails (50) or guide blocks (53) configured further in the longitudinal direction (3) and arranged on the outer side (6) in order to provide a lateral connection possibility for the housings (2) among each other, fastening of the housings (2) to a mounting rail, accommodation of the housings (2) in a switch cabinet and/or the attachment of the housings (2) to other fixtures, in particular standardized attachment devices.

11. Electronic module (1) according to Claim 10, in which the guide rails (50) arranged on the outer side (6) exhibit an undercut arranged transversely to the longitudinal direction for the insertion of connecting elements (58) of partially complementary configuration by means of which two housings (2) can be fixed to each other or the housing (2) can be fixed to mounting rails or attachment devices transversely to the longitudinal direction, wherein the connecting elements (58) preferably exhibit a symmetrical structure in the shape of a double-T, a double dovetail or a bone and can be configured in multiple parts.

12. Electronic module (1) according to one of the previous claims, whose housing (2) can be attached to the housing of a least one other electronic module (1) by means of form-fitting, frictional lock and/or positive-bonding, wherein a safety mechanism (12) is provided which determines the sequence and/or combination possibilities in which the electronic modules can be connected to each other in the longitudinal direction (3) and subsequently be disconnected from each other.

13. Electronic module according to one of the previous claims, in which a safety device which can be shifted by means of an elastic restoring force interrupts the contacting between the non-touch-safe plug and/or clamp connectors (35) and live electronic components (100) or covers live, non-touch-safe plug and/or clamp connectors (35).

14. Electronic module (1) according to one of Claims 4 to 13, in which between two housings (2) positioned adjacently in the longitudinal direction, a thermal insulation plate (33) can be arranged, preferably by means of the through-holes (15), wherein a seal (24) can be arranged between the thermal insulation plate (33) and the relevant end surface (7) of one of the two housings (2).

15. Electronic module (1) according to one of the previous claims, in which several domes (25) and/or cooling fins (30) are configured on the inner sides of the housing wall (4) in such a way that at least one metallic plate (80) can be arranged essentially transversely to the longitudinal direction (3) in a thermally conductive manner so that heat dissipation is possible via the metallic plate to the housing (2), wherein on one or both sides of the at least one plate (80) first circuit boards (110) and/or electronic components (100) can be arranged to be electrically insulated so that these can be wirelessly connected to the second circuit boards (120) for the transmission of electrical power and/or communication signals.

16. Electronic module (1) according to Claim 15, in which, between two metallic plates (80), one or more accumulators or one or more accumulator packs can be attached in the longitudinal direction (3) to a first circuit board (110) which electrically connects the poles of the accumulators via the two metallic plates (80) in the housing (2) and the accumulators or the accumulator packs can be fixed in the housing (2) transversely to the longitudinal direction (3) by means of a casting material, foam material or adjustable wedge devices on at least two adjacent side surfaces in such a way that a swelling of the accumulators or accumulator packs in the longitudinal direction (3) and/or transversely to the longitudinal direction (3) is essentially prevented and heat dissipation is enabled to the housing (2) via the metallic plates (80) and the wedge devices or the casting material or the foam material.

17. Electronic module (1) according to Claim 16, in which forces exerted by the wedge devices acting transversely to the longitudinal direction (3) on the accumulators or accumulator packs can be adjusted by means of adjustment screws which are supported on the metallic plates (80).

18. Electronic module (1) according to one of Claims 1 to 17, in which an electric machine (200) is mounted in the housing (2) with its rotational axis oriented in the longitudinal direction (3) of the electronic module (1), wherein the stator assembly (220) is fixed to the housing and the rotor assembly (210) is mounted by means of a rotor shaft (230) in rotary bearings (240) which are applied to metallic plates (80) arranged in the housing (2) transversely to the longitudinal direction.

19. Electronic module assembly with at least one first electronic module (1) according to Claim 18 comprising an electric machine (200) and at least one second electronic module (1) according to one of Claims 1 to 17, comprising at least one first circuit board (110) and/or at least one second circuit board (120), wherein electrical power and/or communication signals can be transmitted by means of the second circuit boards (120) between the electronic modules (1) and additionally, between the electronic modules (1) which comprise electric machines (200), mechanical power can be transmitted via rotationally fixed connections of the rotor shafts (230) of the electric machines.

20. Electronic module assembly according to Claim 19, wherein power and/or communication signals can be transmitted between the rotor assemblies (210) and/or the stator assemblies (220) and the first circuit boards (110) or electronic components (100) via cables.

## Revendications

1. Module électronique (1) destiné à la réception de composants électroniques (100), avec un boîtier (2) qui est limité dans un sens longitudinal (3) par deux faces frontales (7) présentant chacune une ouverture (8), de telle sorte que le boîtier (2) peut être équipé, par les ouvertures (8), d'au moins un premier circuit imprimé (110) pourvu de composants électroniques (100) et d'au moins un deuxième circuit imprimé (120) pourvu de moyens de connexion par enfichage et/ou par serrage (35), dans lequel sur au moins un deuxième circuit imprimé (120) sont disposés des moyens supplémentaires de connexion par enfichage et/ou par serrage (35, 38) de telle sorte que des moyens de connexion par enfichage et/ou par serrage (35, 38) d'un autre module électronique (1) destiné à transmettre de la puissance électrique et des signaux de communication peuvent être reliés sans fil au au moins deuxième circuit imprimé (120) à l'aide des moyens de connexion par enfichage et/ou par serrage (35, 38),
**caractérisé en ce que** le boîtier (2) présente sur une face intérieure (5) d'une paroi du boîtier (4) au moins un dôme (25) formé dans le sens longitudinal (3), sur lequel le au moins premier circuit imprimé (110) peut être pour l'essentiel fixé perpendiculairement au sens longitudinal (3), et le boîtier (2) présente en outre sur deux faces intérieures (5) situées l'une en face de l'autre et/ou sur deux dômes (25) situés l'un en face de l'autre respectivement un logement de réception (70) destiné à insérer au moins un deuxième circuit imprimé (120) dans le sens longitudinal (3), le au moins premier circuit imprimé (110) et le au moins deuxième circuit imprimé (120) étant, à l'intérieur du boîtier (2), reliés électriquement entre eux sans fil afin de transmettre de la puissance électrique et des signaux de communication par l'intermédiaire de moyens de connexion par enfichage et/ou de serrage (35, 38).

2. Module électronique (1) selon la revendication 1, présentant une pluralité de logements de réception (70) et/ou de fentes (26) s'étendant dans le sens longitudinal (3) et disposés sur des faces intérieures du boîtier (5) et/ou des dômes (25) situés par paires l'un en face de l'autre, dans lequel plusieurs premiers circuits imprimés (110) et/ou deuxièmes circuits imprimés (120) sont disposés dans les logements de réception (70) s'étendant dans le sens longitudinal (3) et les circuits imprimés (110, 120) disposés dans le sens longitudinal (3) peuvent être reliés sans fil à l'aide de moyens de connexion par enfichage et/ou par serrage (35, 38) avec les circuits imprimés (110, 120) disposés perpendiculairement au sens longitudinal (3).

3. Module électronique (1) selon la revendication 1 ou 2, dans lequel le boîtier (2) est fabriqué par formage original à partir d'un métal par procédé d'extrusion, de coulée continue ou de fonte (injectée), de préférence à partir d'aluminium ou d'un alliage d'aluminium, ou à partir de plastique par procédé de moulage par injection ou d'extrusion.

4. Module électronique (1) selon l'une quelconque des revendications précédentes, dans lequel sont disposées sur la paroi du boîtier (4) des ailettes de refroidissement (30) qui s'étendent essentiellement dans des plans parallèles au sens longitudinal et/ou des canaux pour liquides (40) permettant de transmettre un liquide de refroidissement entre les différents boîtiers (2) sont insérés dans la paroi du boîtier (4) dans le sens longitudinal (3).

5. Module électronique (1) selon l'une quelconque des revendications précédentes, dans lequel sur au moins un dôme (25) au moins une attache (60) peut être fixée, de préférence vissée dans le sens longitudinal (3), de telle sorte que la force de serrage agit pour l'essentiel perpendiculairement ou obliquement par rapport au sens longitudinal (3).

6. Module électronique (1) selon la revendication 5, dans lequel un ou plusieurs composants électroniques (130) devant être refroidis pendant le fonctionnement peuvent être pressés en surface contre la face intérieure (5) de la paroi du boîtier (4) au moyen de l'attache (60) et/ou d'une barrette de serrage (62) présentant plusieurs attaches (60), de sorte à permettre une transmission directe de la chaleur depuis le boîtier des composants électroniques (130) sur la paroi du boîtier (4) et/ou à l'attache (60) et/ou à la barrette de serrage (62).

7. Module électronique (1) selon l'une quelconque des revendications précédentes, dans lequel le boîtier (2) présente une paroi de boîtier (4) fermée dans le sens de sa circonférence, similaire à un cadre, profilée et qui est limitée dans le sens longitudinal (3) par les faces frontales (7) de telle sorte que, dans le sens longitudinal (3), plusieurs boîtiers (2) puissent être reliés entre eux en étant mis bout à bout, essentiellement superposés, de préférence par le biais de trous d'interconnexion (15) formés dans la paroi du boîtier (4), un contour d'étanchéité périphérique (20) ou une surface d'étanchéité (22) pouvant être formé(e) sur les faces frontales (7) dans le but de relier de façon étanche aux fluides le boîtier (2) voisin dans le sens longitudinal au moyen d'un joint torique, d'un joint plat, d'un joint à mousse ou d'un joint adhésif (24).

8. Module électronique (1) selon l'une quelconque des revendications 4 ou 7, dans lequel les trous d'interconnexion (15) et/ou les canaux de fluide (40) et/ou les ailettes de refroidissement (30) sont disposés sur la face interne (5) et/ou la face externe (6) de la paroi du boîtier (4) et/ou sur les dômes (25).

9. Module électronique (1) selon l'une quelconque des revendications 7 ou 8, dans lequel les trous d'interconnexion (15) présentent des filetages au moyen desquels, par exemple, des éléments de finition (10), qui ferment le boîtier (2) dans le sens longitudinal (3), peuvent être fixés, la connexion entre le boîtier (2) et les composants de finition (10) pouvant être réalisée de façon étanche aux fluides au moyen d'un joint (4) et les composants de finition (10) pouvant présenter des moyens de connexion par enfichage et/ou par serrage (35) pour relier sans fil et transmettre de la puissance électrique et des signaux de communication vers et depuis les premiers et seconds circuits imprimés (110, 120) disposés dans le boîtier (2).

10. Module électronique (1) selon l'une quelconque des revendications 7 à 9, dans lequel la paroi du boîtier (4) présente en outre dans le sens longitudinal (3) des rails de guidage (50) et/ou des blocs de guidage (53) formés et disposés sur la face externe (6) afin de fournir une possibilité de connexion latérale des boîtiers (2) entre eux, la connexion des boîtiers (2) à un rail de montage, la réception des boîtiers (2) dans une armoire électrique et/ou la fixation des boîtiers (2) sur d'autres dispositifs, notamment sur des dispositifs de fixation normés.

11. Module électronique (1) selon la revendication 10, dans lequel les rails de guidage (50) disposés sur la face externe (6) présentent une contre-dépouille, disposée perpendiculairement au sens longitudinal, pour l'insertion d'éléments de connexion (58) formés de façon complémentaire dans des zones partielles, avec lesquels deux boîtiers (2) peuvent être reliés entre eux ou le boîtier (2) peut être fixé sur des rails de montage ou des dispositifs de fixation perpendiculairement au sens longitudinal, les éléments de connexion (58) présentant de préférence une structure symétrique en forme de double T, d'un guidage en double queue d'aronde ou d'os et pouvant être réalisés en plusieurs parties.

12. Module électronique (1) selon l'une quelconque des revendications précédentes, dont le boîtier (2) peut être relié par engagement positif et/ou par adhérence et/ou par liaison de matière au boîtier d'au moins un autre module électronique (1), dans lequel un mécanisme de sécurité (12) est prévu, qui prescrit l'ordre et/ou les possibilités de combinaisons dans lesquelles les modules électroniques peuvent être reliés entre eux dans le sens longitudinal (3) et à nouveau séparés les uns des autres.

13. Module électronique selon l'une quelconque des revendications précédentes, dans lequel un dispositif de sécurité pouvant être déplacé par une force de rappel élastique interrompt le contact entre des moyens de connexion par enfichage et/ou par serrage (35) protégés contre le contact et des composants électroniques (100) conducteurs de tension ou des moyens de connexion par enfichage et/ou par serrage (35) non protégés contre le contact.

14. Module électronique (1) selon l'une quelconque des revendications 4 à 13, dans lequel une plaque d'isolation thermique (33) peut être disposée entre deux boîtiers (2) voisins dans le sens longitudinal, de préférence au moyen des trous d'interconnexion (15), un joint (24) pouvant être disposé entre la plaque d'isolation thermique (33) et la surface frontale (7) respective d'un des deux boîtiers (2).

15. Module électronique (1) selon l'une quelconque des revendications précédentes, dans lequel plusieurs dômes (25) et/ou ailettes de refroidissement (30) sont formés sur les faces internes de la paroi du boîtier (4) de telle sorte qu'au moins une plaque métallique (80) peut y être disposée pour l'essentiel perpendiculairement au sens longitudinal (3) d'une manière thermiquement conductrice, de façon à ce qu'une dissipation thermique sur le boîtier (2) soit possible via la plaque métallique, des premiers circuits imprimés (110) et/ou des composants électroniques (100) pouvant être disposés sur un ou les deux côtés d'au moins une plaque (80) en étant électriquement isolés de telle sorte que ces derniers puissent être reliés sans fil aux deuxièmes circuits imprimés (120) pour transmettre de la puissance électrique et/ou des signaux de communication.

16. Module électronique (1) selon la revendication 15, dans lequel, entre deux plaques métalliques (80), un ou plusieurs accumulateurs ou packs d'accumulateurs peuvent être fixés dans le boîtier (2) dans le sens longitudinal (3) avec un premier circuit imprimé (110) reliant les pôles des accumulateurs électriques au moyen des deux plaques métalliques (80) et les accumulateurs (140) ou packs d'accumulateurs peuvent être fixés dans le boîtier (2) perpendiculairement au sens longitudinal (3) au moyen d'un matériau de scellement, d'une mousse ou de dispositifs de cales réglables sur au moins deux surfaces latérales voisines de sorte à empêcher substantiellement un gonflement des accumulateurs ou packs d'accumulateurs dans le sens longitudinal (3) et/ou perpendiculairement au sens longitudinal (3) et une dissipation thermique via les plaques métalliques (80) et les dispositifs de cales, le matériau de scellement ou la mousse sur le boîtier (2).

17. Module électronique (1) selon la revendication 16, dans lequel les forces qui sont exercées par les dispositifs de cales perpendiculairement au sens longitudinal (3) sur les accumulateurs ou packs d'accumulateurs peuvent être réglées au moyen de vis de réglage s'appuyant sur les plaques métalliques (80).

18. Module électronique (1) selon l'une quelconque des revendications 1 à 17, dans lequel une machine électrique (200) est intégrée dans le boîtier (2), dont l'axe de rotation est orienté dans le sens longitudinal (3) du module électronique (1), l'ensemble stator (220) étant solidement fixé sur le boîtier et l'ensemble rotor (210) étant amorti au moyen d'un arbre de rotor (230) dans des paliers de rotation (240) qui sont insérés dans des plaques métalliques (80) disposées perpendiculairement au sens longitudinal dans le boîtier (2).

19. Ensemble de module électronique avec au moins un premier module électronique (1) présentant une machine électrique (200) selon la revendication 18 et au moins un deuxième module électronique (1) présentant au moins un premier circuit imprimé (110) et/ou au moins un deuxième circuit imprimé (120) selon l'une quelconque des revendications 1 à 17, dans lequel des signaux de puissance électrique et/ou de communication peuvent être transmis entre les modules électroniques (1) au moyen des deuxièmes circuits imprimés (120) et, en outre, une puissance mécanique peut être transmise entre les modules électroniques (1) présentant des machines électriques (200) par l'intermédiaire des connexions résistant à la rotation des arbres de rotor (230) des machines électriques (200).

20. Ensemble de module électronique selon la revendication 19, dans lequel les signaux de puissance et/ou de communication entre les ensembles rotor (210) et/ou ensembles stator (220) et les premiers circuits imprimés (110) ou composants électroniques (100) peuvent être transmis au moyen de câbles.
